# EUROPÄISCHE PATENTSCHRIFT

(11) **EP 3 231 262 B1**
(45) Veröffentlichungstag und Bekanntmachung des Hinweises auf die Patenterteilung: **13.11.2019**
(21) Anmeldenummer: 15808379.0
(22) Anmeldetag: 10.12.2015
(51) Int. Cl.: H05K 1/02, H05K 1/18, H05K 3/46, H01L 23/00, H01L 23/538, H05K 1/03, H01L 21/56, H05K 3/00

(54) **SEMIFLEXIBLE LEITERPLATTE MIT EINGEBETTETER KOMPONENTE**
SEMI-FLEXIBLE PRINTED CIRCUIT BOARD WITH EMBEDDED COMPONENT
CIRCUIT IMPRIMÉ SEMI-FLEXIBLE AVEC COMPOSANT ENCAPSULÉ

(30) Priorität: 11.12.2014 DE 102014118462
(43) Veröffentlichungstag der Anmeldung: 18.10.2017
(73) Patentinhaber: AT & S Austria Technologie & Systemtechnik Aktiengesellschaft, 8700 Leoben (AT)
(72) Erfinder: STAHR, Hannes, 8605 St.Lorenzen im Mürztal (AT); ZLUC, Andreas, 8700 Leoben (AT); SCHWARZ, Timo, 8770 St. Michael i.O. (AT); WEIDINGER, Gerald, 8700 Leoben (AT)
(74) Vertreter: Dilg, Haeusler, Schindelmann Patentanwaltsgesellschaft mbH
(86) Internationale Anmeldenummer: PCT/EP2015/079206
(87) Internationale Veröffentlichungsnummer: WO 2016/091995

(56) Entgegenhaltungen:
- US-A1- 2002 140 095
- US-A1- 2011 259 630
- US-A1- 2013 277 819
- US-A1- 2013 307 113

## Beschreibung

### Technisches Gebiet

Die vorliegende Erfindung betrifft allgemein das technische Gebiet von Bauelementeträgern bzw. Leiterplatten, auf bzw. an welchen elektronische Baugruppen aufgebaut werden. Die vorliegende Erfindung betrifft insbesondere eine Leiterplatte mit einer eingebetteten elektronischen Komponente und ein Verfahren zum Herstellen einer solchen Leiterplatte.

### Hintergrund der Erfindung

In der modernen Elektronikfertigung wird es zunehmend von Bedeutung bereits bei der Herstellung einer Leiterplatte, auf welcher später eine elektronische Baugruppe mit einer Mehrzahl von elektronischen Bauelementen aufgebaut wird, eine spezielle Komponente wie beispielsweise ein elektronisches Bauelement in die Leiterplatte zu integrieren bzw. einzubetten. Falls es sich bei dem elektronischen Bauelement um ein RFID Bauteil handelt, dann kann auf vergleichsweise einfache Weise eine so genannte Nachverfolgbarkeit (Tracability) vorgenommen werden, bei der eine bestimmte elektronische Baugruppe, welche auf einer entsprechenden Leiterplatte aufgebaut ist, auch bei der Herstellung einer Vielzahl von elektronischen Baugruppen in einer industriellen Elektronikfertigung individuell identifiziert werden kann. Dies ist insbesondere bei sicherheitsrelevanten Baugruppen wie einer Steuereinheit für einen Airbag wichtig, so dass eine ggf. defekte elektronische Baugruppe eindeutig identifiziert werden kann. Nur so kann nämlich gewährleistet werden, dass bei einem Defekt einer solchen Baugruppe gleichartige Baugruppen, welche zur gleichen Zeit mit gleichen elektronischen Bauelementen aufgebaut wurden, beispielsweise im Wege einer Rückrufaktion aus dem Verkehr genommen werden können.

Eine Einbettung von elektronischen Bauelementen in eine Leiterplatte kann jedoch nicht nur während der Herstellung der Leiterplatte sondern auch während des Betriebs einer auf der Leiterplatte aufgebauten elektronischen Baugruppe zu thermischen Verspannungen führen. Dies liegt daran, dass Materialien wie das flammenhemmende Material FR4, welches typischerweise für Leiterplatten verwendet wird, und Halbleitermaterialien wie Silizium (Si), welches typischerweise für elektronische Bauelemente verwendet wird, stark unterschiedliche thermische Ausdehnungskoeffizienten haben. Dies führt naturgemäß zu thermischen Verspannungen. Im Falle einer mehrschichtigen Leiterplatte können sich sogar einzelne Schichten verwerfen und/oder von den anderen Schichten ablösen. Es ist leicht einzusehen, dass solche Verspannungen zu großen mechanischen Belastungen einer elektronischen Baugruppe führen und sowohl die Zuverlässigkeit als auch die Ausfallsicherheit von elektronischen Baugruppen reduzieren.

US 2011/259630 A1 offenbart eine Leiterplatte, die ein Substrat enthält, welches eine elektrisch isolierende Schicht aufweist, in welcher ein Hohlraum ausgebildet ist. Eine elektronische Komponente befindet sich in diesem Hohlraum. Eine Schicht aus einem isolierenden Material ist auf einer Seite des Substrates ausgebildet, um die elektronische Komponente einzubetten bzw. zu bedecken. Anschlusskontakte der elektronischen Komponente sind mit einer ersten strukturierten Verdrahtungsschicht verbunden, welche sich unterhalb der elektrisch isolierenden Schicht befindet. Der thermische Ausdehnungskoeffizient der elektrisch isolierenden Schicht kann einen Wert von 5 ppm/°C bis 30 ppm/°C haben. Das Elastizitätsmodul der elektrisch isolierenden Schicht kann zwischen 10 GPa und 15 GPa liegen. D2 offenbart eine Halbleitervorrichtung mit einem in einem Schichtenverbund eingebetteten Halbleiterchip. Der Schichtenverbund weist mehrere elektrisch isolierende Schichten auf, zwischen welchen jeweils eine elektrisch leitende Verdrahtungsschicht ausgebildet ist. Der Halbleiterchip befindet sich in einer Kavität, welche in den elektrisch isolierenden Schichten ausgebildet ist. An seiner Unterseite ist der Halbleiterchip mittels einer Klebeschicht befestigt. Elektrische Kontakte an der Oberseite des Halbleiterchips sind über metallisierte Vias mit der Verdrahtungsschicht elektrisch leitend verbunden. Die elektrisch isolierenden Schichten können aus einem Epoxidharz hergestellt werden können, welches einen thermischen Ausdehnungs-koeffizienten von ungefähr 8 bis 150 ppm/K und ein Young'sches Elastizitätsmodul von ungefähr 0,03 bis 13 GPa hat.

US 2002/140095 A1 offenbart eine Halbleiterverpackung mit einem eingebetteten Halbleiterchip. Die Halbleiterverpackung weist eine Basis auf, an deren Rändern elektrische Anschlüsse ausgebildet sind. Auf der Basis bzw. auf den elektrischen Anschlüssen ist eine strukturierte Verdrahtungsschicht ausgebildet, auf welcher sich eine Harzschicht befindet. Auf der Harzschicht sowie auf dem Bereich der Basis, welcher nicht von der Verdrahtungsschicht bedeckt ist, befindet sich eine Harz-Vergussmasse, in welcher eine Kavität ausgebildet ist, in der sich der Halbleiterchip befindet. Die Harz-Vergussmasse kann aus einem thermoplastischen Harz bestehen, welches einen thermischen Ausdehnungskoeffizienten von 10 bis 18 ppm/K sowie ein Elastizitätsmodul E von 10 bis 20 GPa hat.

D4: US 2013/0277819 A1 offenbart eine Halbleitervorrichtung mit einem Gehäuse aus einem thermoplastischen Harz. In dem Gehäuse ist eine innere Ausnehmung ausgebildet, welche zu einer Seite der Halbleitervorrichtung geöffnet ist. In der inneren Ausnehmung befindet sich ein Kernstück der Halbleitervorrichtung. Das Kernstück umfasst ein Substrat, ein Halbleiterelement, welches auf dem Substrat montiert ist, einen Bonddraht, welcher das Substrat und das Halbleiterelement elektrisch verbindet, und eine Harz-Vergussmasse, welche das Substrat, das Halbleiterelement und den Bonddraht verschließt. Das thermoplastische Harz der Vergussmasse kann ein Elastizitätsmodul von beispielsweise 18 GPa haben. Die Vergussmasse kann einen linearen thermischen Ausdehnungskoeffizienten von 17 ppm/K haben.

Der vorliegenden Erfindung liegt die Aufgabe zugrunde, eine Leiterplatte mit einer eingebetteten elektronischen Komponente sowie ein Verfahren zur Herstellung einer solchen Leiterplatte anzugeben, so dass elektronische Baugruppen aufgebaut werden können, welche auch bei starken Temperaturänderungen nur geringen mechanischen Belastungen ausgesetzt sind.

### Zusammenfassung der Erfindung

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird eine Leiterplatte beschrieben, welche die Merkmale des unabhängigen Anspruchs 1 aufweist.

Der vorliegenden Erfindung liegt die Erkenntnis zugrunde, dass Komponenten in ein neuartiges Material eingebettet werden können, so dass Temperaturänderungen keinen oder nur wenig mechanischen Stress erzeugen. In Bezug auf eine Leiterplatte kann eine Komponente, zwei Komponenten oder auch mehr als zwei Komponenten eingebettet werden. Das Material, welches in diesem Dokument als dielektrisches Material bezeichnet ist, bildet die erfindungsgemäße dielektrische Schicht. Das dielektrische Material ist im Vergleich zu dem bekannten flammenhemmenden Material FR4 relativ weich und nachgiebig. Durch diese Eigenschaft kommt es nur zu geringen thermisch induzierten mechanischen Belastungen, so dass Verwerfungen einer Schicht der beschriebenen Leiterplatte zuverlässig vermieden werden können. Aufgrund der geringen thermisch induzierten internen mechanischen Belastungen werden auch die (internen) Anschlüsse der eingebetteten elektrischen Komponente nur einem geringen mechanischen Stress ausgesetzt. Ferner werden auch die Oberflächen der eingebetteten Komponente, welche mit dem dielektrischen Material in Kontakt stehen, durch Temperaturänderungen nur wenig mechanisch belastet, so dass die Komponente auf mechanisch schonende Weise in der Leiterplatte eingebettet ist.

Die metallische Schicht kann an der dielektrischen Schicht unmittelbar, d.h. direkt, oder mittelbar, d.h. indirekt über eine oder mehrere Zwischenschichten, angebracht sein.

Es wird darauf hingewiesen, dass die vorstehend beschriebenen aus technischer Sicht überraschenden Effekte von den Erfindern auch experimentell nachgewiesen werden konnten, indem eine erfindungsgemäße Leiterplatte in sog. Reflow-Tests eine ausgezeichnete mechanische Stabilität gezeigt hat. Bei solchen Reflow-Tests wird die Leiterplatte ausgehend von Raumtemperatur solch hohen Temperaturen ausgesetzt, welche typischerweise in einem Reflow-Ofen vorkommen und welche ausreichen, um Lotpaste, welche sich zwischen Bauelement-Anschlusskontakten von bestückten Bauelementen und Anschlusspads auf der Oberfläche einer Leiterplatte befindet, aufzuschmelzen und die betreffenden Bauelemente an der Oberseite der Leiterplatte anzulöten. Erfindungsgemäße Leiterplatten haben mindestens zehn Reflow-Zyklen unbeschädigt überstanden, wobei ein Reflow-Zyklus eine Temperaturänderung von Raumtemperatur auf eine bestimmte Reflow-Temperatur und zurück umfasst.

Das erfindungsgemäße dielektrische Material weist einen thermischen Ausdehnungskoeffizienten im Bereich zwischen Null und 17°ppm/K auf. In diesem Zusammenhang wird darauf hingewiesen, dass es aus technischer Sicht kein Problem ist, ein Material mit einem thermischen Ausdehnungskoeffizienten von Null herzustellen. Es ist nämlich allgemein bekannt, dass es auch Materialien, insbesondere Kunststoffmaterialien, mit einem negativen thermischen Ausdehnungskoeffizienten gibt. Um ein Material mit einem thermischen Ausdehnungskoeffizienten von Null herzustellen, ist es also lediglich erforderlich, ein Material mit einem negativen thermischen Ausdehnungskoeffizienten und ein Material mit einem positiven thermischen Ausdehnungskoeffizienten in geeigneter Weise zu mischen, so dass sich die positive und negative Ausdehnung zumindest annähernd kompensieren. Nachfolgend wird der Begriff thermischer Ausdehnungskoeffizient auch als CTE (Coefficient of Thermal Expansion) bezeichnet.

Hinsichtlich des Wertebereichs des Elastizitätsmoduls E von 1 GPa bis 20 GPa sind die Erfinder zu der Erkenntnis gelangt, dass sich die untere Grenze von 1 GPa dadurch ergibt, dass das dielektrische Material für eine prozesssichere Verarbeitung und insbesondere für einem Vorgang des Verpressens oder Presssens der verschiedenen Schichten der Leiterplatte nicht zu weich sein darf. Bei einem Überschreiten der oberen Grenze von 20 GPa ergibt sich für einen solchen Vorgang des Verpressens kein ausreichendes Fließverhalten.

Es wird darauf hingewiesen, dass sich die in diesem Dokument genannten Werte für das Elastizitätsmodul E auf eine Temperatur von 25°C beziehen.

Wie bereits vorstehend erwähnt führt die Verwendung des erfindungsgemäßen dielektrischen Materials zu einer derart stressfreien Einbettung der Komponente, so dass es zu keinen oder zu nahezu keinen Verwerfungen von zumindest einer Schicht der Leiterplatte kommt. Insbesondere hat sich herausgestellt, dass nach dem Vorgang des Einbettens der Komponente in zumindest eine der beiden dielektrischen Schichten mögliche Verwerfungen schwächer als 1% sind, so dass die mit der eingebetteten Komponente versehene Leiterplatte problemlos weiterverarbeitet werden kann. In diesem Zusammenhang kann eine Weiterverarbeitung insbesondere darin bestehen, dass die erfindungsgemäße Leiterplatte mit weiteren (elektronischen) Bauelementen bestückt und/oder in einem Reflow Ofen verlötet wird. Ferner bedeutet in diesem Zusammenhang eine Verwerfung von weniger als 1%, dass eine Verwerfungshöhe der betreffenden Schicht (entlang der z-Richtung) im Verhältnis zu einer Länge der betreffenden Schicht (in einer xy-Ebene, welche senkrecht zu der z-Richtung ist) kleiner als 1% ist.

Aufgrund der Möglichkeit die Komponente in zumindest eine der beiden dielektrischen Schichten stressarm einzubetten, kann die erfindungsgemäße Leiterplatte auch mit vergleichsweise großen Komponenten versehen werden, welche beispielsweise eine Fläche von 10mm x 10mm haben. Außerdem führen die geringen thermisch induzierten mechanischen Belastungen auch zu einer Reduktion des mechanischen Stresses auf elektrische Verbindungen zu und/oder von der Komponente, wenn die erfindungsgemäße Leiterplatte im Rahmen einer weiteren Elektronikfertigung mit anderen herkömmlichen Leiterplatten beispielsweise zu einer mehrlagigen Leiterplatte verbunden wird.

Die erfindungsgemäße Leiterplatte kann auf besonders vorteilhafte Weise für so genannte Leistungsmodule verwendet werden, welche mit bzw. bei einer großen elektrischen Leistung arbeiten und bei welchen es naturgemäß aufgrund von nie zu vermeidenden elektrischen Verlusten zu einer großen Wärmeentwicklung kommt. Bei der Herstellung von solchen Leistungsmodulen werden typischerweise mehrere mit Hochleistungsbauteilen bestückte Leiterplatten in geeigneter Weise miteinander verbunden, so dass diese innerhalb eines relativ kleinen Bauraums angeordnet sind und es demzufolge zu einer sehr starken Wärmeentwicklung insbesondere im Inneren dieses Bauraums kommt. Demzufolge ist für solche Anwendungen die erfindungsgemäße Leiterplatte, welche eine besonders hohe thermische Stabilität aufweist, besonders geeignet.

Es wird darauf hingewiesen, dass die beschriebenen Wertebereiche des erfindungsgemäßen dielektrischen Materials eine derzeit ideale Kombination von Elastizitätsmodul und CTE darstellen. Dabei ist nämlich zum einen die thermische Ausdehnung so klein, dass es nur zu sehr kleinen thermischen Verspannungen kommen kann, und zum anderen ist die Steifigkeit des dielektrischen Materials (a) so klein, dass möglicherweise vorhandene geringe thermische Ausdehnungen aufgefangen werden können, und (b) so groß, dass das dielektrische Materials auf gewöhnliche Weise weiterverarbeitet werden kann.

Gemäß einem Ausführungsbeispiel der Erfindung wird die mit einer eingebetteten Komponente beschriebene Leiterplatte mit einem Material gebildet, welches in der EP 2 666 806 A1 beschrieben ist. Dieses Material wird aus einem Fasersubstrat und einer Schicht aus einer unter Wärme aushärtbaren Harzzusammensetzung hergestellt. Diese Schicht enthält eine modifizierte Siloxanverbindung oder eine Verbindung mit einem Grundgerüst aus einer modifizierten Siloxanverbindung.

Die beschriebene metallische Schicht kann insbesondere eine Kupferschicht sein, welche aus einer Kupferfolie resultiert. Bei der Herstellung der beschriebenen Leiterplatte aus einem Schichtverbund bestehend zumindest aus der eingebetteten Komponente, der dielektrischen Schicht und der beschriebenen Metallschicht kann die Kupferfolie im einfachsten Fall über die anderen Komponenten der Leiterplatte gelegt werden und mit diesen zusammen später zu einem Verbund verpresst werden. Selbstverständlich sind für die beschriebene Leiterplatte auch Schichtaufbauten möglich, welche mehr als eine metallische Schicht und/oder mehr als eine dielektrische Schicht aufweisen.

Unter dem Begriff "eingebettet" kann in diesem Dokument verstanden werden, dass die Komponente von mehreren Seiten von dem betreffenden Material bzw. der betreffenden Schicht umgeben ist. Dabei kann die betreffende Seite der Komponente vollständig oder lediglich teilweise von dem betreffenden Material bzw. der betreffenden Schicht bedeckt sein. Ein eingebetteter Zustand der Komponente kann im Fall einer quaderförmigen Geometrie der Komponente (d.h. eine Komponente mit insgesamt 6 Seitenflächen) insbesondere dann vorliegen, (a) wenn die untere Seitenfläche und die vier Seitenflächen von dem Einbettungsmaterial bedeckt sind, (b) wenn lediglich die vier Seitenflächen von dem Einbettungsmaterial bedeckt sind, (c) wenn die untere Seitenfläche vollständig und die vier Seitenflächen lediglich teilweise von dem Einbettungsmaterial bedeckt sind, oder (d) wenn lediglich die vier Seitenflächen lediglich teilweise von dem Einbettungsmaterial bedeckt sind.

Die Komponente kann eine elektronische Komponente sein, welche wiederum jedes beliebige aktive oder passive elektronische Bauelement sein kann. In diesem Zusammenhang kann die elektronische Komponente eine weitere Leiterplatte, ein Modul (eine vollständig oder teilweise mit Bauelementen bestückte Leiterplatte), eine Batterie und/oder eine MEMS Struktur sein. Die Komponente kann jedoch auch eine "nicht-elektronische" Komponente, beispielsweise ein Kühlelement, sein, welches insbesondere aus einem metallischen Material besteht.

Erfindungsgemäß weist das dielektrische Material ein Kriechverhalten auf, welches durch zumindest eine der folgenden Eigenschaften bestimmt ist: (a) eine plastische Verformbarkeit im Bereich zwischen 0,01% und 10%, insbesondere im Bereich zwischen 0,1% und 5% und weiter insbesondere im Bereich zwischen 0,2% und 2%, und/oder (b) eine viscoelastische Verformbarkeit im Bereich zwischen 0% und 10%, insbesondere im Bereich zwischen 0% und 5% und weiter insbesondere im Bereich zwischen 0% und 3%.

Der Begriff "Verformbarkeit" kann in diesem Dokument insbesondere die Fähigkeit des dielektrischen Materials beschreiben, ohne eine Zerstörung der inneren Struktur (beispielsweise durch das Ausbilden von Hohlräumen) seine Abmessung (entlang einer Raumrichtung) zu ändern. Die genannten Parameterwerte beziehen sich daher auf eine Längenänderung (insbesondere unter Zug) eines Materialstreifens. Es wird davon ausgegangen, dass bei einer solchen Längenänderung das Volumen des betreffenden Materialstreifens zumindest annähernd gleich bleibt. Anschaulich ausgedrückt wird bei einer Dehnung des Materialstreifens entlang seiner Längsrichtung der Materialstreifen (senkrecht zu seiner Längsrichtung) dünner.

Es wird darauf hingewiesen, dass sich die hier angegebenen Parameterwerte für die plastische Verformbarkeit und die viscoelastische Verformbarkeit auf Raumtemperatur (20°C) beziehen.

Es wird ferner darauf hingewiesen, dass die Kriecheigenschaft des beschriebenen dielektrischen Materials zumindest annähernd isotrop ist. Dies bedeutet, dass das Kriechverhalten der dielektrischen Schicht in allen Raumrichtungen zumindest ungefähr gleich ist.

Die beschriebene Kriecheigenschaft bzw. das Kriechverhalten des dielektrischen Materials hat den Vorteil, dass bei der Herstellung der Leiterplatte und insbesondere bei einem Verpressen der verschiedenen Leiterplattenschichten das dielektrische Material sich in Hohlräume hinein erstreckt und dort verbleibt. Diese Hohlräume können absichtlich oder versehentlich gegeben sein. Insbesondere können solche Hohlräume bewusst im Bereich der Komponente oder angrenzend zu der Komponente vorgesehen sein, um so eine sichere und schonende Einbettung der Komponente zu erreichen. Die vorstehend beschriebenen Wertebereiche für das Elastizitätsmodul und den CTE stellen in Verbindung mit der hier beschriebenen Kriecheigenschaft eine ideale Kombination für eine sichere und schonende Einbettung der Komponente dar. Die hier beschriebene Kriecheigenschaft hat nämlich den Effekt, dass während eines Aushärtens des Materials dieses für eine gewisse Zeit noch eine gewisse Verschiebbarkeit aufweist. Es ergibt sich also eine gewisse Relaxationszeit, in welcher das Material elastisch aber insbesondere auch plastisch verformbar bleibt. Innerhalb dieser Relaxationszeit und Kriechzeit sollte insbesondere der Vorgang des Verpressens der verschiedenen Schichten der erfindungsgemäßen Leiterplatte zumindest annähernd vollständig durchgeführt werden.

Gemäß einem weiteren Ausführungsbeispiel der Erfindung ist das dielektrische Material eine Mischung oder ein Copolymer bestehend aus zumindest einem ersten Material mit einem ersten Elastizitätsmodul E und einem ersten thermischen Ausdehnungskoeffizienten und einem zweiten Material mit einem zweiten Elastizitätsmodul E und einem zweiten thermischen Ausdehnungskoeffizienten. Der erste Elastizitätsmodul ist größer als der zweite Elastizitätsmodul und der erste thermische Ausdehnungskoeffizient ist kleiner als der zweite thermische Ausdehnungskoeffizient.

Anschaulich ausgedrückt ist das erste Material im Vergleich zu dem zweiten Material härter und weist einen kleineren CTE auf. Durch die Wahl eines geeigneten Mischungsverhältnisses oder Copolymerisationsverhältnisses zwischen dem ersten Material und dem zweiten Material kann auf relativ einfache Weise das vorstehend beschriebene dielektrische Material hergestellt werden, welches das gewünschte Elastizitätsmodul E und den gewünschten CTE aufweist.

Gemäß einem weiteren Ausführungsbeispiel der Erfindung weist das erste Material eine erste Glasübergangstemperatur auf und das zweite Material weist eine zweite Glasübergangstemperatur auf. Die erste Glasübergangstemperatur ist größer als die zweite Glasübergangstemperatur.

Durch die Wahl zweier Materialien mit unterschiedlicher Glasübergangstemperatur (Tg) kann durch eine Mischung oder Copolymerisation der beiden Materialien auf besonders einfache Weise das vorstehend beschriebene dielektrische Material hergestellt werden, welches den gewünschten Elastizitätsmodul E und den gewünschten CTE aufweist.

Die erste Tg kann beispielsweise im Bereich zwischen 150°C und 190°C und insbesondere im Bereich zwischen 160°C und 180°C liegen. Bevorzugt ist die erste Tg zumindest annähernd 170°C. Die zweite Tg kann beispielsweise im Bereich zwischen 0°C und 70°C und insbesondere im Bereich zwischen 10°C und 30°C liegen. Bevorzugt liegt die erste Tg zumindest annähernd bei Raumtemperatur (20°C).

Gemäß einem weiteren Ausführungsbeispiel der Erfindung weist das erste Material ein Harz und einen sich darin befindlichen harten Füllstoff auf. Das Harz kann beispielsweise ein Phenol-Harz oder ein Epoxidharz, beispielsweise ein bromiertes Bisphenol A Epoxidharz sein. Der Füllstoff kann beispielsweise Glas, Quarz, und/oder Aluminiumhydroxid sein. Mit einem solchen Füllstoff kann auf besonders einfache Weise ein geringer Wert für den CTE des ersten Materials eingestellt werden. Bevorzugt kann der Füllstoff kleine SiO₂ Kugeln oder Partikel aufweisen, welche von dem Harz ummantelt sind.

Gemäß einem weiteren Ausführungsbeispiel der Erfindung weist das zweite Material ein thermisch aushärtbares Harz auf, welches mit einem weichmachenden Stoff verbunden ist. Mittels einer geeigneten Dosierung des weichmachenden Stoffes kann die gewünschte Härte bzw. Weichheit des dielektrischen Materials auf einfache und genaue Weise eingestellt werden.

Der weichmachende Stoff kann z. B. ein aliphatischer Polyester oder Polyether sein, wobei bei der Polyaddition ein elastisches Blockcopolymer entsteht.

Gemäß einem weiteren Ausführungsbeispiel der Erfindung liegt der Wert für das Elastizitätsmodul E im Bereich zwischen 2 und 7 GPa und insbesondere im Bereich zwischen 3 und 5 GPa. Mit einem Elastizitätsmodul in diesen Bereichen kann ein besonders guter Kompromiss zwischen (a) einer möglichst spannungsfreien Einbettung der Komponente und (b) einer guten Verarbeitbarkeit der dielektrischen Schicht erreicht werden.

Gemäß einem weiteren Ausführungsbeispiel der Erfindung liegt der thermische Ausdehnungskoeffizient im Bereich zwischen 3 und 10 ppm/K und insbesondere im Bereich zwischen 5 und 8 ppm/K.

Gemäß einer derzeit als am besten angesehenen Ausführungsform beträgt der CTE des dielektrischen Materials zumindest annähernd 6 ppm/K. Damit ist der CTE des dielektrischen Materials ungefähr gleich wie der CTE von elektronischen Bauelementen, welche demzufolge besonders spannungsfrei in die Leiterplatte eingebettet werden können. In diesem Zusammenhang wird darauf hingewiesen, dass der CTE von elektronischen Bauelementen im Wesentlichen durch den CTE von Silizium bestimmt ist, welches einen CTE Wert von ungefähr 3 ppm/K aufweist.

Gemäß einem weiteren Ausführungsbeispiel der Erfindung weist die Leiterplatte ferner die dielektrische Kern-Schicht auf, welche flächig an der metallischen Schicht und/oder an der dielektrischen Schicht angebracht ist. Gemäß dem hier dargestellten Ausführungsbeispiel ist die Komponente in der dielektrischen Kern-Schicht eingebettet und die dielektrische Schicht ist oberhalb oder unterhalb der dielektrischen Kern-Schicht sowie der eingebetteten Komponente angeordnet.

Bevorzugt ist die Komponente ausschließlich in der dielektrischen Kern-Schicht eingebettet. Außerdem kann die dielektrische Kern-Schicht zwischen zwei dielektrischen Schichten angeordnet sein. Weiter bevorzugt befindet sich die dielektrische Schicht unmittelbar auf der dielektrischen Kern-Schicht bzw. der Komponente. Anschaulich ausgedrückt stellt die dielektrische Schicht eine Deckelstruktur für die Komponente dar. Damit befindet sich die dielektrische Schicht, welche für die Spannungsfreiheit in der beschriebenen Leiterplatte in besonderem Maße verantwortlich ist, unmittelbar an der Komponente, deren Einbettung damit zumindest annähernd perfekt spannungsfrei ist.

In diesem Zusammenhang erscheinen derzeit insbesondere Schichtaufbauten interessant zu sein, welche durch eine Kombination einer relativ steifen dielektrischen Kern-Schicht, welche einem geringen Schrumpf aufweist, mit der in diesem Dokument beschriebenen dielektrischen Schicht entstehen. Hier kann nämlich neben der stressarmen Einbettung der Komponente auch eine gute Dimensionsstabilität gewährleistet werden, welche insbesondere für einen weiteren Aufbau hin zu einer qualitativ hochwertigen Mehrfachschicht-Leiterplatte (Multilayer Leiterplatte) wichtig ist.

Die hier beschriebene Steifigkeit der dielektrischen Kern-Schicht kann beispielsweise dadurch erreicht werden, dass für die dielektrische Kern-Schicht ein aushärtbares Material verwendet wird, welches im Verlauf der Herstellung der beschriebenen Leiterplatte ausgehärtet wird.

Gemäß einem weiteren Ausführungsbeispiel der Erfindung ist die Komponente in der dielektrischen Kern-Schicht eingeklebt. Dies ermöglicht auf vorteilhafte Weise eine besonders stabile Einbettung der Komponente in der dielektrischen Kern-Schicht.

Bevorzugt ist in dieser Ausführungsform die dielektrische Kern-Schicht ein steifer Kern, welcher auf beiden flächigen Seiten mit einer dielektrischen Schicht versehen ist. Das Anbringen der beiden dielektrischen Schichten kann in bekannter Weise mittels laminieren erfolgen, um einen stabilen Schichtverbund mit der eingebetteten Komponente zu erzeugen.

Gemäß einem weiteren Ausführungsbeispiel der Erfindung weist die dielektrische Kern-Schicht ein dielektrisches Kern-Material auf, welches entlang der x-Achse und entlang der y-Achse einen thermischen Ausdehnungskoeffizienten von 0 bis 11 ppm/K, insbesondere von 2 bis 10 ppm/K und weiter bevorzugt von 3 bis 9ppm/K hat. Dies hat den Vorteil, dass der Kern der Leiterplatte aus einem Material besteht, welches einen CTE in der Größenordnung von dem CTE von der eingebetteten Komponente bzw. von Si aufweist. Das Kern-Material kann, insbesondere wenn es sich um ein ausgehärtetes Kern-Material handelt, einen hohen Elastizitätsmodul E haben, um Kräfte, welche beim Vorgang eines Laminierens entstehen, aufnehmen zu können und damit nicht an die eingebettete Komponente weiterzuleiten. In einem Spalt zwischen der eingebetteten Komponente und dem Kern-Material kann sich das vorstehend beschriebene dielektrische Material mit seinem vergleichsweise niedrigen Elastizitätsmodul E befinden. Aufgrund dieses niedrigen Elastizitätsmoduls E kann es auf vorteilhafte Weise Spannungen ausgleichen.

In diesem Zusammenhang wird darauf hingewiesen, dass durch eine thermische Anpassung der Ausdehnungskoeffizienten des dielektrischen Kern-Materials und der Komponente folgende vorteilhafte Effekte erzielt werden können:
(A) Die Betriebszuverlässigkeit einer auf der Leiterplatte aufgebauten elektronischen Schaltung, welche optional die eingebettete Komponente enthalten kann, kann im Vergleich zu bekannten Leiterplattenaufbauten insbesondere bei schwankenden thermischen Bedingungen verbessert werden.
(B) Auch bei thermischen Nachfolgeprozessen werden keine oder nur zu vernachlässigende mechanische Spannungen in den Schichtverbund der beschriebenen Leiterplatte eingebracht. Dadurch entsteht ein Verbund mit geringer Verwerfung. Dies gilt selbst bei einem Flächenanteil der eingebetteten Komponente(n) im Vergleich zu der Gesamtfläche der beschriebenen Leiterplatte von mehr als 30%.

Gemäß einem weiteren Ausführungsbeispiel der Erfindung ist die Komponente in der dielektrischen Schicht eingebettet.

Falls die beschriebene Leiterplatte zusätzlich die vorstehend beschriebene dielektrische Kern-Schicht aufweist, befindet sich die Komponente bevorzugt ausschließlich in der dielektrischen Schicht.

Es wird darauf hingewiesen, dass die Verwendung der vorstehend beschriebenen dielektrischen Kern-Schicht für die in diesem Dokument beschriebene Leiterplatte optional ist. Auch wenn die dielektrische Kern-Schicht der beschriebenen Leiterplatte eine gewisse mechanische Festigkeit verleiht, was in vielen Anwendungen von Vorteil ist, so kann eine erfindungsgemäße Leiterplatte insbesondere dann auch ohne dielektrische Kern-Schicht aufgebaut werden, wenn es sich um eine flexible Leiterplatte handeln soll.

Gemäß einem weiteren Ausführungsbeispiel der Erfindung ist die dielektrische Schicht eine dielektrische Prepreg-Schicht ist und/oder das dielektrische Material ist ein dielektrisches Prepreg-Material. Dies hat den Vorteil, dass die beschriebene Leiterplatte fertigungstechnisch auf besonders effiziente Weise aufgebaut werden kann.

Unter dem Begriff "Prepreg-Schicht" kann in diesem Dokument ein vorgefertigtes dielektrisches schichtförmige Substrat verstanden werden, welches aus dem "Prepreg-Material" aufgebaut ist. In diesem Zusammenhang ist Prepreg die englische Kurzform für "preimpregnated fibers", was auf Deutsch "vorimprägnierte Fasern" bedeutet. Ein Prepreg ist ein Halbzeug, bestehend aus Lang- oder Endlosfasern und einer vorgetrockneten bzw. vorgehärteten, jedoch noch nicht polymerisierten duroplastischen Kunststoffmatrix, das v. a. im Leichtbau Verwendung findet. Die enthaltenen Fasern können als reine unidirektionale Schicht, als Gewebe oder als Gelege vorliegen.

Gemäß einem weiteren Ausführungsbeispiel der Erfindung ist die Gesamtdicke des Schichtenverbundes kleiner als ungefähr 200 µm, insbesondere kleiner als ungefähr 190 µm und weiter insbesondere kleiner als ungefähr 180 µm. In von den Erfindern bereits realisierten Ausführungsbeispielen hat der Schichtenverbund sogar eine Gesamtdicke von lediglich 170 µm bzw. von 150 µm und ist damit dünner als ungefähr 175 µm.

Es wird darauf hingewiesen, dass die erreichbaren minimalen Dicken der Leiterplatten von der Höhe der eingebetteten Komponente abhängen. In diesem Zusammenhang beziehen sich die vorstehend genannten Dicken auf eine eingebettete Komponente mit einer Höhe von 150 µm.

Es wird ferner darauf hingewiesen, dass die Dicke des Schichtenverbundes gleich sein kann wie die Dicke der gesamten Leiterplatte. Mit der hier beschriebenen Kombination aus dielektrischem Material und asymmetrischen Aufbau können bei einer eingebetteten Komponente mit einer Dicke von 150 µm somit stabile Leiterplatten bzw. Leiterplattenstrukturen aufgebaut werden, welche um bis zu 20% dünner sind als herkömmliche Leiterplatten mit einer derartigen eingebetteten Komponente.

Die Leiterplatte kann lediglich auf einer Seite, das heißt entweder oberhalb oder unterhalb der eingebetteten Komponente eine mechanische Stützstruktur aufweisen. Es wird darauf hingewiesen, dass eine solche Struktur nur unter Verwendung der in diesem Dokument beschriebenen dielektrischen Schicht möglich ist, weil nur diese die für einen solchen Aufbau erforderliche Elastizität und thermische Ausdehnung aufweist.

Gemäß einem weiteren Ausführungsbeispiel der Erfindung weist die Leiterplatte in Bezug zu einer Ebene der eingebetteten Komponente entlang einer Achse einen asymmetrischen Aufbau auf. Dabei ist die Ebene parallel zu der flächigen Oberfläche der dielektrischen Schicht orientiert. Außerdem schneidet die Ebene die eingebettete Komponente in der Mitte und die Achse steht senkrecht zu dieser Ebene.

Unter dem Begriff "Aufbau" der Leiterplatte ist in diesem Dokument insbesondere eine Folge von Schichten zu verstehen, welche jeweils durch eine bestimmte Dicke und durch ein bestimmtes Material charakterisiert sind. Im Falle eines asymmetrischen Aufbaus ist die Schichtenfolge oberhalb der eingebetteten Komponente hinsichtlich der Schichtmaterialien und/oder hinsichtlich der Schichtdicken unterschiedlich zu der Schichtenfolge unterhalb der eingebetteten Komponente.

Ein asymmetrischer Aufbau kann insbesondere dazu beitragen, dass die Leiterplatte in einer besonders flachen bzw. dünnen Schichtstruktur realisiert werden kann. Insbesondere kann die beschriebene Leiterplatte lediglich auf einer Seite, das heißt entweder oberhalb oder unterhalb der eingebetteten Komponente eine mechanische Stützstruktur aufweisen. Es wird darauf hingewiesen, dass eine solche Struktur nur unter Verwendung der in diesem Dokument beschriebenen dielektrischen Schicht möglich ist, weil nur diese die für einen solchen Aufbau erforderliche Elastizität und thermische Ausdehnung aufweist.

Gemäß einem weiteren Aspekt der Erfindung wird ein Verfahren zum Herstellen einer Leiterplatte und insbesondere zum Herstellen einer Leiterplatte des vorstehend genannten Typs beschrieben. Das Verfahren weist die Merkmale des unabhängigen Anspruchs 9 auf.

Auch dem beschriebenen Verfahren liegt die Erkenntnis zugrunde, dass durch die Verwendung einer dielektrischen Schicht, welche aus dem dielektrischen Material mit seinen erfindungsgemäßen Wertebereichen für das Elastizitätsmodul E und den thermischen Ausdehnungskoeffizienten besteht bzw. dieses Material aufweist, eine Leiterplattenstruktur geschaffen werden kann, welche auch bei starken Temperaturänderungen weitgehend frei von mechanischen Spannungen bleibt. Dies reduziert zum einen die Fehleranfälligkeit bei thermischen Belastungen während des Betriebs einer auf der Leiterplatte aufgebauten elektronischen Schaltung. Zum anderen kann auch die Herstellung der Leiterplatte selbst sowie deren weitere Verarbeitung, beispielsweise die Anbindung an eine andere Leiterplatte, erleichtert werden.

Die dielektrische Kern-Schicht kann an der dielektrischen Schicht unmittelbar, d.h. direkt, oder mittelbar, d.h. indirekt über eine oder mehrere Zwischenschichten, angebracht sein.

Gemäß einem Ausführungsbeispiel der Erfindung weist das Verfahren ferner ein Ausbilden einer Ausnehmung in der dielektrischen Schicht und/oder in der dielektrischen Kern-Schicht auf. Ferner weist das Einbetten der Komponente ein Einbringen der Komponente in die Ausnehmung auf.

Gemäß einem Ausführungsbeispiel der Erfindung weist das Einbetten der Komponente ferner ein Einbringen eines adhäsiven Materials in die Ausnehmung auf.

Das adhäsive Material kann ein niederviskoser Klebstoff sein, welcher die Eigenschaft hat, eine möglichst feste Verbindung sowohl (a) mit dem Material der Komponente als auch (b) mit der dielektrischen Schicht und/oder mit einer dielektrischen Kern-Schicht einzugehen. Dadurch kann eine besonders hohe mechanische Stabilität der Einbettung der Komponente erreicht werden.

Abhängig von der Verpackung der Komponente sollte der Klebstoff derart beschaffen sein, dass er eine gute Verbindung zu einem Halbleitermaterial, insbesondere Silizium, (falls es sich bei der Komponente um einen ungehäusten Chip bzw. Bare Die handelt) oder zu einem typischen Verpackungsmaterial eines Bauelements hat (falls es sich bei der Komponente um einen gehäusten Chip handelt).

Gemäß einem Ausführungsbeispiel der Erfindung ist die Ausnehmung größer ist als die Komponente, so dass nach einem Einbringen der Komponente in die Ausnehmung ein Hohlraum verbleibt. In diesen Hohlraum kann im Laufe des weiteren Prozessierens der Leiterplatte das dielektrische Material eindringen, so dass die eingebettete Komponente von verschiedenen Seiten mit dem dielektrischen Material umgeben ist. Dadurch ergibt sich auf vorteilhafte Weise eine besonders stressfreie Einbettung der Komponente in die Leiterplatte.

Gemäß einem weiteren Ausführungsbeispiel der Erfindung weist das Verfahren ferner auf (A) falls die Komponente in der dielektrischen Schicht eingebettet ist, ein Aufbringen einer weiteren dielektrischen Schicht auf die dielektrische Schicht und die Komponente, wobei die weitere dielektrische Schicht die gleichen Eigenschaften hat wie die dielektrische Schicht und (B) falls die Komponente in der dielektrischen Kern-Schicht eingebettet ist, ein Aufbringen der dielektrischen Schicht auf die dielektrische Kern-Schicht und die Komponente.

Anschaulich ausgedrückt stellt gemäß dem hier beschriebenen Ausführungsbeispiel die aufgebrachte weitere dielektrische Schicht bzw. die aufgebrachte dielektrische Schicht eine Deckelstruktur dar, welche für eine gute mechanische Stabilität bei einer weiterhin stressfreien Einbettung der Komponente sorgt. Dies gilt insbesondere auch bei Temperaturschwankungen, die während der weiteren Herstellung einer Baugruppe auf der beschriebenen Leiterplatte und/oder während eines Betriebs der auf der beschriebenen Leiterplatte aufgebauten Baugruppe auftreten können.

Gemäß einem weiteren Ausführungsbeispiel der Erfindung weist das Verfahren ferner ein Ausbilden einer metallischen Schicht an der dielektrischen Schicht auf.

Die metallische Schicht kann insbesondere eine Kupferschicht sein, welche später in geeigneter Weise strukturiert werden kann, um Leiterbahnen für (in Bezug zu der Leiterplatte externe) elektronische Bauelemente einer auf der Leiterplatte bestückten elektronischen Baugruppe bereitzustellen. Ferner können solche Leiterbahnen auch dazu verwendet werden, die eingebettete (in Bezug zu der Leiterplatte interne) Komponente zu kontaktieren. Dafür können in bekannter Weise auch Vias verwendet werden, welche insbesondere in der die Komponente bedeckenden dielektrischen Schicht beispielsweise mittels Laserbohrens ausgebildet und nachfolgend in bekannter Weise metallisiert werden können, um eine Kontaktierung senkrecht zu der Ebene der Schichten der Leiterplatte zu realisieren.

Gemäß einem weiteren Ausführungsbeispiel der Erfindung weist das Verfahren ferner ein Verpressen sämtlicher Schichten der Leiterplatte auf.

Durch ein geeignetes Verpressen kann aus dem zuvor vergleichsweise losen Schichtenaufbau der Leiterplatte auf einfache Weise ein mechanisch stabiler Schichtenverbund entstehen. Es wird jedoch darauf hingewiesen, dass insbesondere in Abhängigkeit der gesamten Dicke des Schichtenverbundes die Leiterplatte noch eine gewisse Flexibilität aufweisen kann.

Gemäß einem weiteren Ausführungsbeispiel der Erfindung wird ein Verfahren zum Herstellen von zwei prozessierten Leiterplatten beschrieben. Dieses Verfahren weist die Merkmale des unabhängigen Anspruchs 14 auf.

Dem beschriebenen Verfahren liegt die Erkenntnis zu Grunde, dass ein symmetrisch aufgebauter Schichtenverbund mit all seinen Vorteilen bei dessen Herstellung und Prozessierung verwendet werden kann, um mittels eines geeigneten Auftrennens an einer Ablöseschicht zwei asymmetrische Leiterplatten herzustellen, welche die vorstehend beschriebenen Vorteile, insbesondere die besonders geringe Gesamtdicke, aufweisen.

Bei dem hier beschriebenen Verfahren stellen die zwei zumindest teilweise unprozessierten Leiterplatten, welche zu dem Schichtenverbund aufgebaut werden, ein Halbzeug dar. Die Verbindung dieser beiden Halbzeuge, welche jeweils zumindest eine der vorstehend beschriebenen dielektrischen Schichten aufweisen, erfolgt bevorzugt an ausgewählten Stellen mittels eines Verpressens. Die ausgewählten Stellen können insbesondere durch Punkte gegeben sein, welche bei der weiteren Prozessführung nicht mehr benötigt bzw. von der weiteren Prozessführung nicht mehr beeinflusst werden.

Nach dem Verpressen können in vorteilhafter Weise beide Halbzeuge gleichzeitig bearbeitet werden, wobei auf die Vorteile eines asymmetrischen Aufbaus nicht verzichtet werden muss. Diese Bearbeitung bzw. Prozessierung kann alle notwendigen Arbeitsschritte bei einer Leiterplattenfertigung umfassen. Die Arbeitsschritte können beispielsweise ein weiteres Aufbauen von Schichten, ein Bohren von Vias, ein Fotoätzen, etc. umfassen. Durch ein Ablösen der prozessierten ersten Leiterplatte von der prozessierten zweiten Leiterplatte an der Ablöseschicht erhält man auf einfache Weise zwei asymmetrische Leiterplatten, die in einem einzigen Prozessablauf hergestellt wurden. Nachfolgend können an den beiden einzelnen prozessierten asymmetrischen Leiterplatten letzte Finishing-Prozesse wie beispielsweise eine Abscheiden von Goldschichten, ein Konturfräsen, etc. erfolgen.

Gemäß einem Ausführungsbeispiel der Erfindung weist der aufgebaute Schichtenverbund entlang der z-Achse eine Symmetrieebene auf, welche parallel zu der xy-Ebene orientiert ist.

Gemäß einem weiteren Ausführungsbeispiel der Erfindung weist die Ablöseschicht ein druckfähiges Haftreduzierungsmaterial auf, welches mittels eines Druckverfahrens und insbesondere mittels eines Siebdruckverfahrens auf zumindest einen Teilbereich der ersten Leiterplatte oder auf zumindest einen Teilbereich der zweiten Leiterplatte transferiert wird. Ein solches Haftreduzierungsmaterial, welches auch als Haftverhinderungsmaterial bezeichnet wird, ist beispielsweise in der WO 2010/085830 A1 beschrieben und setzt sich aus einem Haftverhinderungsadditiv, einem Bindemittel und einem Lösungsmittel zusammen. Ein solches Haftverhinderungsmittel kann vor einem Laminieren bzw. einem Verpressen des betreffenden Schichtenverbundes strukturiert auf die gewünschte Oberfläche der betreffenden Leiterplatte gedruckt werden und erlaubt nach dem Laminieren und einem Durchtrennen der seitlichen Begrenzung des strukturierten Bereichs eine Trennung der beiden (Teile der) Leiterplatten innerhalb des strukturierten Bereichs. Eine solche Vorgangsweise zum Trennen ist deutlich einfacher und kostengünstiger durchzuführen als beispielsweise eine andere Vorgehensweise, bei der anstelle des Haftreduzierungsmaterial vor dem Vorgang des Laminierens bzw. Verpressens zwischen die beiden Leiterplatten eine Trennfolie (z.B. eine Teflonfolie) eingelegt wird.

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

### Kurze Beschreibung der Zeichnung

Figur 1 zeigt in einer Querschnittsdarstellung die Herstellung einer Leiterplatte gemäß einem ersten Ausführungsbeispiel mit zwei eingebetteten elektronischen Komponenten, welche zu Beginn der Herstellung lediglich auf einer Metallfolie aufgebracht sind.
Figur 2 zeigt in einer Querschnittsdarstellung die Herstellung einer Leiterplatte gemäß einem zweiten Ausführungsbeispiel mit zwei eingebetteten elektronischen Komponenten, welche zu Beginn der Herstellung auf einer Sandwichstruktur aufgebracht sind, welche zwischen zwei metallischen Schichten eine dielektrische Kern-Schicht aufweist.
Figur 3 zeigt in einer Querschnittsdarstellung die Herstellung einer Leiterplatte gemäß einem dritten Ausführungsbeispiel unter Verwendung eines temporären Trägers.
Figuren 4a bis 4c illustrieren ein Reduzieren der Dicke einer mit einer eingebetteten elektronischen Komponente hergestellten Leiterplatte bei Verwenden des in diesem Dokument beschriebenen dielektrischen Materials.
Figuren 5a, 5b und 5c illustrieren die Herstellung einer symmetrischen Leiterplattenstruktur mit zwei Halbzeugen, welche jeweils eine asymmetrische Leiterplatte sind.

### Detaillierte Beschreibung

Es wird darauf hingewiesen, dass in der folgenden detaillierten Beschreibung Merkmale bzw. Komponenten von unterschiedlichen Ausführungsformen, die mit den entsprechenden Merkmalen bzw. Komponenten von einer anderen Ausführungsform nach gleich oder zumindest funktionsgleich sind, mit den gleichen Bezugszeichen oder mit einem Bezugszeichen versehen sind, welches sich von dem Bezugszeichen der gleichen oder zumindest funktionsgleichen Merkmale bzw. Komponenten lediglich in der ersten Ziffer unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebenen Ausführungsformen lediglich eine beschränkte Auswahl an möglichen Ausführungsvarianten der Erfindung darstellen. Insbesondere ist es möglich, die Merkmale einzelner Ausführungsformen in geeigneter Weise miteinander zu kombinieren, so dass für den Fachmann mit den hier explizit dargestellten Ausführungsvarianten eine Vielzahl von verschiedenen Ausführungsformen als offensichtlich offenbart anzusehen sind.

Außerdem wird darauf hingewiesen, dass raumbezogene Begriffe, wie beispielsweise "vorne" und "hinten", "oben" und "unten", "links" und "rechts", etc. verwendet werden, um die Beziehung eines Elements zu einem anderen Element oder zu anderen Elementen zu beschreiben, wie in den Figuren veranschaulicht. Demnach können die raumbezogenen Begriffe für Ausrichtungen gelten, welche sich von den Ausrichtungen unterscheiden, die in den Figuren dargestellt sind. Es versteht sich jedoch von selbst, dass sich alle solchen raumbezogenen Begriffe der Einfachheit der Beschreibung halber auf die in den Zeichnungen dargestellten Ausrichtungen beziehen und nicht unbedingt einschränkend sind, da die jeweils dargestellte Vorrichtung, Komponente etc., wenn sie in Verwendung ist, Ausrichtungen annehmen kann, die von den in der Zeichnung dargestellten Ausrichtungen verschieden sein können.

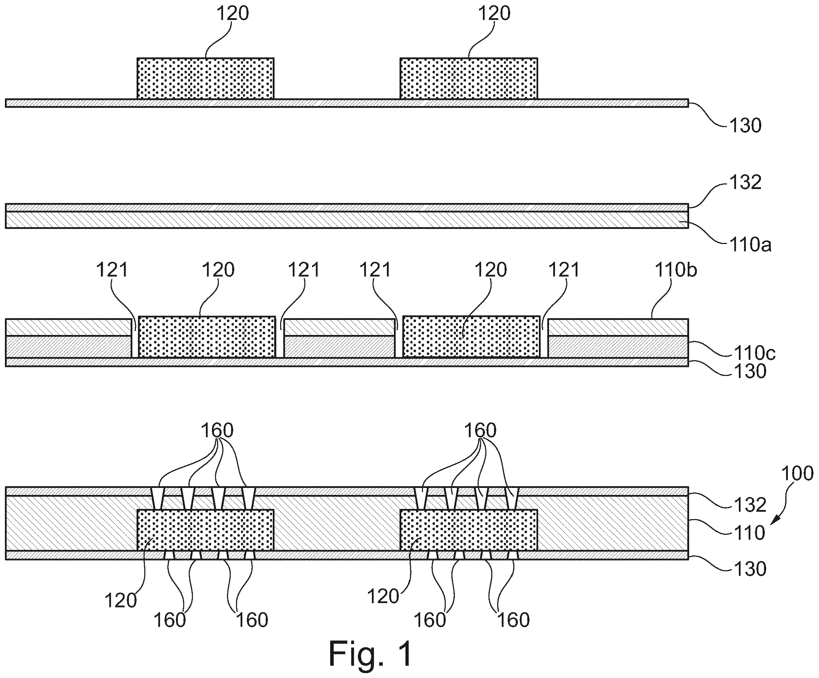

Figur 1 illustriert in einer Querschnittsdarstellung anhand von drei Schritten die Herstellung einer Leiterplatte 100 gemäß einem ersten Ausführungsbeispiel der Erfindung. Wie aus der unteren Darstellung von Figur 1 ersichtlich, sind in der Leiterplatte zwei elektronische Komponenten 120 eingebettet, welche aktive Bauelemente, passive Bauelemente und insbesondere ein RFID Bauelement sein können. Es wird darauf hingewiesen, dass die Leiterplatte 100 nach deren Herstellung auch in mehrere einzelne Leiterplatten aufgeteilt bzw. vereinzelt werden kann, so dass beispielsweise in jeder einzelnen Leiterplatte lediglich eine elektronische Komponente 120 eingebettet ist.

In der oberen Darstellung von Figur 1 ist dargestellt, dass gemäß dem hier dargestellten Ausführungsbeispiel die beiden elektronischen Komponenten 120 zunächst auf einer metallischen Schicht 130 aufgebracht werden. Da gemäß dem hier dargestellten Ausführungsbeispiel keine Trägerstruktur für die metallische Schicht 130 verwendet wird, handelt es sich bei der metallischen Schicht 130 um eine Metallfolie. Die Metallfolie 130 besteht bevorzugt aus Kupfer.

Wie aus der mittleren Darstellung von Figur 1 ersichtlich, wird auf der Metallfolie 130 neben den elektronischen Komponenten 120 zunächst eine dielektrische Teilschicht 110c und danach auf die dielektrische Teilschicht 110c eine weitere dielektrische Teilschicht 100b aufgebracht. Gemäß dem hier dargestellten Ausführungsbeispiel ist die obere Oberfläche der weiteren dielektrischen Teilschicht 100b bündig mit der Oberseite der elektronischen Komponente 120. Wie ferner aus der Figur 1 ersichtlich, reichen die beiden Schichten 110b und 110c nicht ganz bis an die Seitenwand der elektronischen Komponente 120 heran, so dass sich in der 2D Schnittdarstellung ein Spalt 121 ergibt, welcher in real, d.h. in 3D, eine Beabstandung ist, welche die elektronische Komponente 120 umgibt.

An dieser Stelle wird darauf hingewiesen, dass die elektronischen Komponenten 120 so genannte Bare Dies bzw. ungehäuste Chips sein können. Alternativ können die elektronischen Komponenten 120 auch gehäuste elektronische Bauelemente sein, welche an zumindest einer ihrer Außenseiten in Figur 1 nicht dargestellte metallische Kontaktstrukturen bzw. Kontaktpads aufweisen.

Wie ferner aus der mittleren Darstellung von Figur 1 ersichtlich, wird gemäß dem hier dargestellten Ausführungsbeispiel eine Deckelstruktur vorbereitet. Diese Deckelstruktur umfasst gemäß dem hier dargestellten Ausführungsbeispiel eine weitere dielektrische Teilschicht 110a, welche an der Unterseite einer ebenfalls als Metallfolie ausgebildeten metallischen Schicht 132 ausgebildet ist.

Wie aus der unteren Darstellung von Figur 1 ersichtlich, wird die Deckelstruktur bestehend aus der Metallfolie 132 und der dielektrischen Teilschicht 110a von oben auf die Grundstruktur aufgesetzt, deren Oberseite durch die obere Fläche der beiden elektronischen Komponenten 120 sowie durch die obere Oberfläche der dielektrischen Teilschicht 110b gebildet ist. Danach wird der gesamte Schichtenaufbau in bekannter Weise verpresst. Dabei vereinigen sich die drei dielektrischen Teilschichten 110a, 110b und 110c zu einer einheitlichen dielektrischen Schicht, welche in Figur 1 mit dem Bezugszeichen 110 gekennzeichnet ist. Infolge einer gewissen Fließfähigkeit des dielektrischen Materials wird bei dem Verpressen auch die Beabstandung 121 aufgefüllt.

Nach dem Vorgang des Verpressens können in bekannter Weise beispielsweise mittels Laserbohrens Vias 160 ausgebildet werden. Gemäß dem hier dargestellten Ausführungsbeispiel erstrecken sich diese Vias 160 sowohl von oben als auch von unten bis hin zu den beiden elektronischen Komponenten 120. Durch eine Metallisierung dieser Vias 160 können die elektronischen Komponenten 120 später in geeigneter Weise elektrisch kontaktiert werden.

Es wird darauf hingewiesen, dass sämtliche dielektrische Teilschichten 110a, 110b und 110c und die dielektrische Schicht 110, welche für die Herstellung der Leiterplatte 100 verwendet werden, die in diesem Dokument vorstehend beschriebenen Eigenschaften hinsichtlich der Elastizität (das Elastizitätsmodul E liegt im Bereich zwischen 1 und 20 GPa) und der thermischen Ausdehnung (der thermische Ausdehnungskoeffizient CTE liegt im Bereich zwischen 0 und 17 ppm/K) haben. Gleiches gilt übrigens für die nachfolgend beschriebenen Leiterplatten 200, 300, 400a, 400b und 400c.

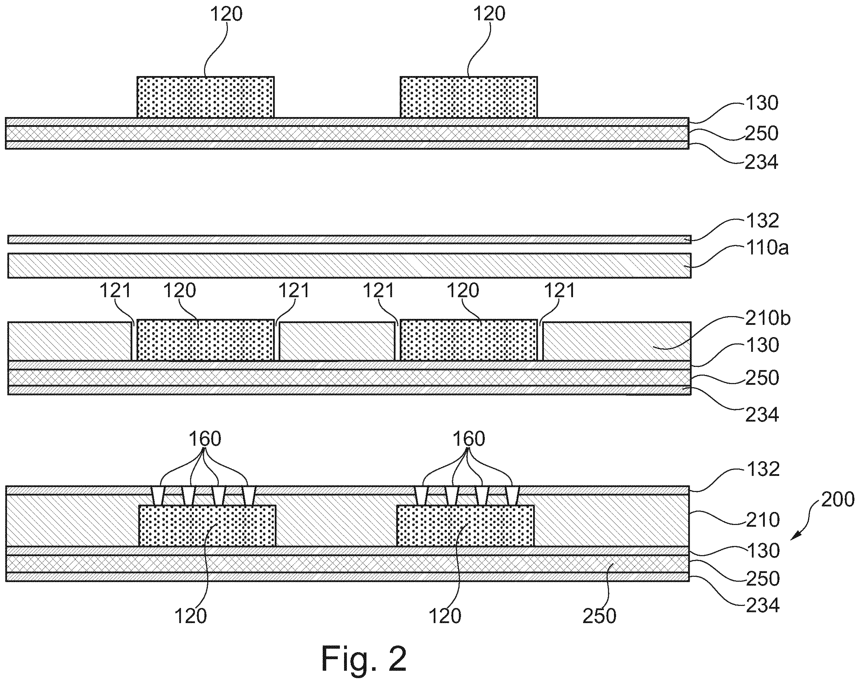

Figur 2 zeigt in einer Querschnittsdarstellung die Herstellung einer Leiterplatte 200 gemäß einem zweiten Ausführungsbeispiel der Erfindung. Auch die Leiterplatte 200 weist zwei eingebettete elektronische Komponenten 120 auf. Im Unterschied zu der in Figur 1 dargestellten Leiterplatte 100 sind die beiden elektronischen Komponenten 120, wie aus der oberen Darstellung von Figur 2 ersichtlich, zunächst auf einer Sandwichstruktur aufgebracht. Diese Sandwichstruktur umfasst gemäß dem hier dargestellten Ausführungsbeispiel eine dielektrische Kern-Schicht 250, die sich zwischen zwei metallischen Schichten bzw. Metallfolien 130 und 234 befindet. Im Vergleich zu der Verwendung von lediglich einer Metallfolie 130, wie es in Figur 1 dargestellt ist, stellt die Sandwichstruktur 130, 250, 234 eine deutlich stabilere Trägerstruktur für die beiden elektronischen Komponenten 120 dar. Dies erleichtert auf vorteilhafte Weise die Handhabung der Trägerstruktur für die beiden elektronischen Komponenten.

Die weiteren Verfahrensschritte zur Herstellung der Leiterplatte 200 unterscheiden sich lediglich in zwei Aspekten von den Verfahrensschritten zur Herstellung der Leiterplatte 100, die in Figur 1 dargestellt ist. Aus diesem Grund werden diese weiteren Verfahrensschritte an dieser Stelle nicht noch einmal im Detail erläutert und es werden lediglich die beiden Unterschiede im Vergleich zu Figur 1 beschrieben.

Es wird darauf hingewiesen, dass zumindest eine der vorstehend beschriebenen dielektrischen Schichten auch eine dielektrische Prepreg-Schicht sein kann, welche die in diesem Dokument beschriebenen besonderen mechanischen und thermischen Eigenschaften hat und welche ein Materialverbund aus Glasfasern und Harz darstellt. Gleiches gilt auch für die nachfolgend beschriebenen Ausführungsbeispiele.

Wie aus der mittleren Darstellung von Figur 2 ersichtlich, befindet sich oberhalb der metallischen Schicht 130 lediglich eine einzige dielektrische Teilschicht 210b und nicht zwei zunächst verschiedene dielektrische Teilschicht 110b und 110c (vgl. Figur 1). In der unteren Darstellung von Figur 2 haben sich die beiden dielektrischen Teilschichten 110a und 210b (durch einen Verpressvorgang) zu einer einheitlichen dielektrischen Teilschicht 210 verbunden.

Wie aus der unteren Darstellung von Figur 2 ersichtlich, werden gemäß dem hier dargestellten Ausführungsbeispiel die Vias 160 lediglich von oben ausgebildet und erstrecken sich demzufolge lediglich von oben zu den elektronischen Komponenten 120. Damit können die elektronischen Komponenten 120 lediglich auf einer Seite elektrisch kontaktiert werden. Dies stellt jedoch für die meisten elektronischen Komponenten keine Einschränkung dar, da diese ohnehin lediglich elektrische Anschlusskontakte an einer ihrer Seiten aufweisen.

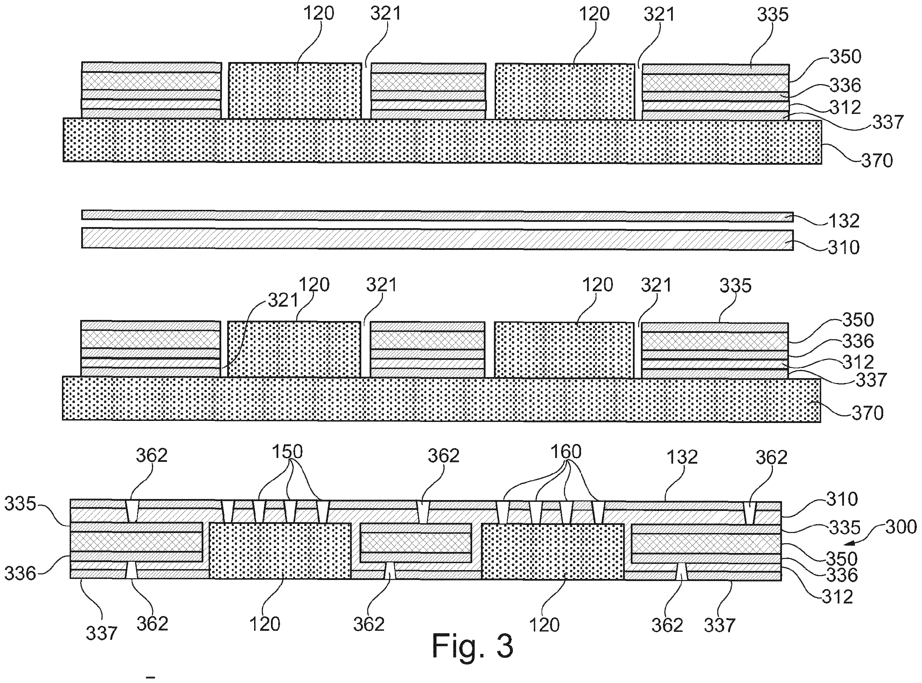

Figur 3 zeigt in einer Querschnittsdarstellung die Herstellung einer Leiterplatte 300 gemäß einem dritten Ausführungsbeispiel der Erfindung. Wie aus der oberen Darstellung von Figur 3 ersichtlich, werden die beiden eingebetteten elektronischen Komponenten 120 zunächst auf einer Oberseite eines temporären Trägers 370 angebracht. Gemäß dem hier dargestellten Ausführungsbeispiel ist dieser temporäre Träger 370 eine adhäsive Folie, welche häufig auch als Tape bezeichnet wird.

Auf den temporären Träger 370 wird ferner (neben den elektronischen Komponenten 120) eine Schichtenfolge aufgebracht, welche gemäß dem hier dargestellten Ausführungsbeispiel aus folgenden Schichten besteht: (a) einer metallischen Schicht 337, (b) einer dielektrischen Schicht 312, (c) einer metallischen Schicht 336, (d) einer dielektrischen Kern-Schicht 350 sowie (e) einer metallischen Schicht 335.

Gemäß dem hier dargestellten Ausführungsbeispiel wird bei dem Ausbilden der o.g. Schichtenfolge jeweils zwischen einer Seitenwand der elektronischen Komponente 120 und derjenigen Seitenwand der Schichtenfolge, welche der elektronischen Komponente 120 zugewandt ist, ein Spalt bzw. eine Beabstandung 321 freigelassen. Diese Spalte bzw. Beabstandungen 321 können bereits bei einen sukzessiven Aufbringen der betreffenden Schichten der Schichtenfolge freigelassen werden. Alternativ können diese Spalten bzw. Beabstandungen 321 auch nach einen vollständigen Ausbilden einer Schichtenfolge, welche sich bis an die Seitenwand der elektronischen Komponente 120 erstreckt, durch eine geeignete Abtragung beispielsweise mittels eines Ätzvorgangs ausgebildet werden.

Wie aus der mittleren Darstellung von Figur 3 ersichtlich, wird ferner eine Deckelstruktur bereitgestellt, welche gemäß dem hier dargestellten Ausführungsbeispiel eine Metallfolie 132 und eine an der Unterseite der Metallfolie 132 ausgebildete weitere dielektrische Schicht 310 umfasst.

Nach einem Aufsetzen der Trägerstruktur wird der resultierende Schichtenverbund verpresst. Dieses Verpressen kann insbesondere gemeinsam mit dem temporären Träger 370 erfolgen. Falls das Verpressen gemeinsam mit dem temporären Träger 370 erfolgt, dann wird dieser nach dem Vorgang des Verpressens von der verpressten Leiterplatte 300 entfernt (vgl. untere Darstellung von Figur 3).

Auch in diesem Ausführungsbeispiel füllen sich bei dem Verpressen die Beabstandungen 321 mit dem dielektrischen Material, welches, wie vorstehend beschrieben, eine gewisse Kriechfähigkeit aufweist. Im Ergebnis ist daher die betreffende elektronische Komponente 120 zumindest weitgehend vollständig von dem dielektrischen Material mit seinen vorteilhaften Eigenschaften bezüglich Elastizität und thermischer Ausdehnung umgeben.

Wie aus der unteren Darstellung von Figur 3 ersichtlich, werden in der Leiterplatte 330 nicht nur die von der Leiterplatte 200 bekannten Vias 160 ausgebildet. Gemäß dem hier dargestellten Ausführungsbeispiel werden in der Leiterplatte 300 ferner Vias 362 ausgebildet, welche sich von oben nach unten bis auf die metallische Schicht 336 bzw. von unten nach oben bis auf die metallische Schicht 337 erstrecken. Über diese Vias 362 können in bekannter Weise nach einer geeigneten Metallisierung die metallischen Schichten 336 bzw. 337 elektrisch kontaktiert werden.

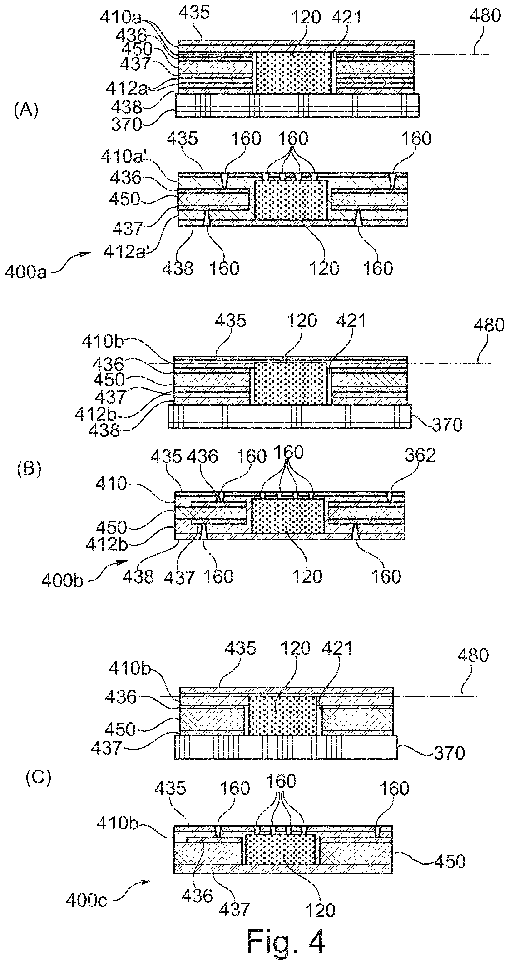

Die Figuren 4a bis 4c illustrieren verschiedenen Leiterplatten 400a, 400b und 400c, welche verschiedene Dicken haben. Gemäß dem hier dargestellten Ausführungsformen hat die Leiterplatte 400a (ohne den temporären Träger 370) eine Dicke von ungefähr 220 µm. Dies entspricht der Dicke von bekannten Leiterplatten mit eingebetteten Komponenten. Die Leiterplatte 400b hat eine Dicke von ungefähr 185 µm und die Leiterplatte 400c hat eine Dicke von ungefähr 170 µm. Die dünnste Leiterplatte 400c ist damit um ca. 20% dünner als die Leiterplatte 400a, welche trotz der Verwendung des in diesem Dokument im Detail beschriebenen dielektrischen Materials nicht dünner ist als eine vergleichbare herkömmliche Leiterplatte. Es wird darauf hingewiesen, dass in der Realität die Dicken der Leiterplatten von der Höhe der eingebetteten Komponente abhängen. Die vorstehend genannten Dicken beziehen sich auf eine eingebettete Komponente mit einer Höhe von 150 µm.

In den oberen Darstellungen der Figuren 4a bis 4c ist der Schichtenverbund der jeweiligen Leiterplatte 400a, 400b bzw. 400c in einem unverpressten Zustand zusammen mit dem jeweiligen temporären Träger 370 dargestellt. In den unteren Darstellungen der Figuren 4a bis 4c ist die fertige verpresste Leiterplatte 400a, 400b bzw. 400c jeweils ohne den entsprechenden temporären Träger dargestellt.

Wie aus Figur 4a ersichtlich, ist oberhalb des temporären Trägers 370 eine Schichtstruktur aufgebaut, welche gemäß dem hier dargestellten Ausführungsbeispiel von unten nach oben die folgenden Schichten umfasst: (a) eine metallische Schicht 438, (b) zwei dielektrische Teilschichten 412a, (c) eine metallische Schicht 437, (d) eine dielektrische Kern-Schicht 450, (e) eine metallische Schicht 436, (f) zwei dielektrische Teilschichten 410a und (g) eine metallische Schicht 435.

Gemäß dem hier dargestellten Ausführungsbeispiel ist innerhalb dieser Schichtenstruktur eine Kavität ausgebildet, in welcher sich eine elektronische Komponente 120 befindet. Diese Kavität wurde während des Aufbauens der Schichtenstruktur nach dem Ausbilden der unteren dielektrischen Teilschicht 410a ausgebildet. Erst nach einem Einsetzen der elektronischen Komponente 120 wurden die verbleibenden Schichten, das heißt die obere dielektrische Teilschicht 410a und die metallische Schicht 435 ausgebildet.

Wie aus Figur 4a ersichtlich, ist die Breite der Kavität etwas größer als die Breite der elektronischen Komponente 120. Wie aus der unteren Darstellung von Figur 4a ersichtlich, wird der entsprechende Hohlraum 421 jedoch bei einem Verpressen der Schichtenfolge infolge einer Fließfähigkeit des dielektrischen Materials aufgefüllt. Dadurch ergibt sich eine Verbindung zwischen (a) der dielektrischen Schicht 410a', welche durch ein druckinduziertes Verbinden der beiden dielektrischen Teilschichten 410a entsteht, und (b) der dielektrischen Schicht 412a', welche durch ein druckinduziertes Verbinden der beiden dielektrischen Teilschichten 412a entsteht. Damit ist die elektronische Komponente 120 an verschiedenen Seiten von dem erfindungsgemäßen dielektrischen Material umgeben, so dass sich eine besonders stressfreie Einbettung der elektronischen Komponente 120 in die Leiterplatte 400a ergibt.

Es wird darauf hingewiesen, dass die Höhe der in Figur 4a gezeigten Kavität größer sein kann als die Dicke der elektronischen Komponente 120. Dies hat den Vorteil, dass bei einem Verpressen kein bzw. nur sehr wenig Druck auf die elektronische Komponente 120 Bauteil ausgeübt wird.

Der Vollständigkeit halber wird noch erwähnt, dass auch in der Leiterplatte 400a geeignete Vias 160 und 362 ausgebildet werden können, welche nach einer in bekannter Weise durchgeführten Metallisierung elektrische Verbindungen erzeugen, die sich in vertikaler Richtung erstrecken. Wie aus der unteren Darstellung von Figur 4a ersichtlich, sorgen die Vias 160 für eine elektrische Verbindung zwischen der elektronischen Komponente 120 und der Metallschicht 435. Mittels der Vias 362 können die beiden inneren metallischen Schichten 436 und 437 mit der jeweils benachbarten äußeren metallischen Schicht 435 bzw. 438 elektrisch leitend verbunden werden.

In Figur 4b ist die Herstellung einer Leiterplatte 400b dargestellt, welche sich von der Herstellung der Leiterplatte 400a darin unterscheidet, dass anstelle der dielektrischen Teilschichten 410a und 412a von Anfang an eine einheitliche dielektrische Schicht 410b bzw. 412b verwendet wird. Die Leiterplatte 400b unterscheidet sich von der Leiterplatte 400a ferner dadurch, dass die elektronische Komponente 120 bereits vor dem Vorgang des Verpressens des Schichtenverbundes in die obere dielektrische Schicht 410b hinein gedrückt wurde. Der Unterschied in der Höhe zwischen dem Hohlraum 421 und der elektronischen Komponente 120 liegt im Bereich zwischen ca. 5 µm und 15 µm. Ein solches Eindrücken der elektronische Komponente 120 ist ohne eine Beschädigung derselben nur deshalb möglich, weil das Material der oberen dielektrischen Schicht 410b die in diesem Dokument beschriebenen herausragenden Eigenschaften in Bezug auf das Elastizitätsmodul E und den thermischen Ausdehnungskoeffizienten hat. Bei der Verwendung eines herkömmlichen dielektrischen (Prepreg-)Materials würde ein solches Hineindrücken zu einer Zerstörung der elektronischen Komponente 120 führen. In diesem Zusammenhang ist es prozesstechnisch auch von Bedeutung, dass das verwendete dielektrische Material auch noch bei Temperaturen von unter 100°C und insbesondere sogar noch bei Raumtemperatur die in diesem Dokument beschriebene Verformbarkeit aufweist. Auch in Figur 4b ist das Eindringen des dielektrischen Materials in den Hohlraum 421 innerhalb der Kavität, in welcher sich die elektronische Komponente 120 befindet, zu erkennen.

In Figur 4c ist die Herstellung einer Leiterplatte 400c dargestellt, welche sich von der Herstellung der Leiterplatte 400b darin unterscheidet, dass die untere dielektrische Schicht 412b sowie die untere metallische Schicht 438 nicht verwendet werden. Es wird darauf hingewiesen, dass das Weglassen der metallischen Schicht 438 und insbesondere das Weglassen der dielektrischen Schicht 412b lediglich deshalb möglich ist, weil das dielektrische Material der verbleibenden dielektrischen Schicht 410b die in diesem Dokument beschriebenen herausragenden Eigenschaften hinsichtlich seiner Elastizität sowie hinsichtlich seiner thermischen Ausdehnung aufweist. Ferner ist bei der Leiterplatte 400c die Kavität für die elektronische Komponente 120 in einem strukturierten Kern bestehend aus den Schichten 437, 450 und 436 ausgebildet. Wie aus der oberen Abbildung von Figur 4C ersichtlich, ist die elektronische Komponente 120 höher als der Kern bzw. als die Kavität. Beim Verpressen stellt die dielektrische Schicht 410b das Material zur Verfügung, welches in den Hohlraum 421 eindringt und die elektronische Komponente 120 auf mechanisch schonende Weise umgibt.

Die Reduktion der Aufbaustärke ist in den Figuren 4a bis 4c jeweils durch eine "Strich-Punkt-Linie" 480 veranschaulicht, welche die Oberseite der elektronischen Komponente 120 angibt. Anhand dieser "Strich-Punkt-Linie" 480 kann die Höhe des Schichtenaufbaus oberhalb der elektronischen Komponente 120 deutlich erkannt werden. In diesem Zusammenhang wird noch einmal darauf hingewiesen, dass das in den Figuren 4a bis 4c illustrierte Reduzieren der Dicke einer mit einer eingebetteten elektronischen Komponente 120 hergestellten Leiterplatte 400c in der Praxis nur mit dem in diesem Dokument beschriebenen dielektrischen Material möglich ist, weil andere dielektrischen Materialen zu Leiterplatten führen würden, welche die heutzutage sehr hohen Qualitätsanforderungen insbesondere hinsichtlich ihrer mechanischen und thermischen Stabilität in keiner Weise erfüllen könnten.

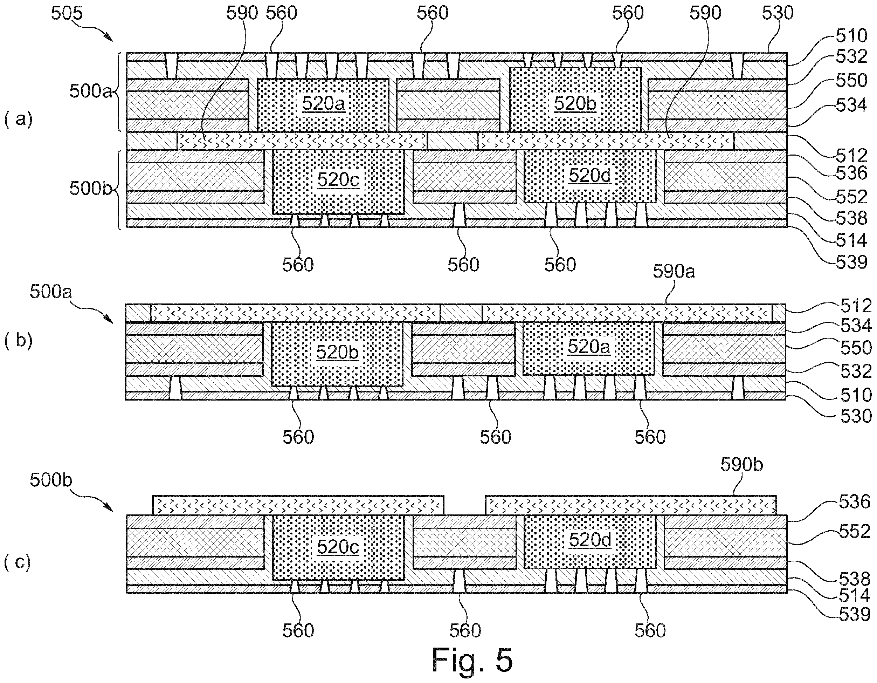

Die Figuren 5a, 5b und 5c illustrieren das Auftrennen einer symmetrischen Leiterplattenstruktur 505 in zwei asymmetrische Leiterplatten 500a und 500b. Wie aus Figur 5a ersichtlich, weist gemäß dem hier dargestellten Ausführungsbeispiel die im wesentlichen symmetrische Leiterplattenstruktur 505 von oben nach unten folgenden Schichtaufbau auf:
- eine metallische Schicht 530
- eine dielektrische Schicht 510
- eine metallische Schicht 532
- eine dielektrische Kern-Schicht 550
- eine metallische Schicht 534
- eine dielektrische Schicht 512 sowie eine Ablöseschicht 590, welche jeweils in verschiedenen flächigen Teilbereichen innerhalb einer zur vertikalen z-Achse senkrechten xy-Ebene in dem dargestellten Schichtenverbund eine gemeinsame Schicht bilden
- eine metallische Schicht 536
- eine dielektrische Kern-Schicht 552
- eine metallische Schicht 538
- eine dielektrische Schicht 514
- eine metallische Schicht 539

An diese Stelle wird darauf hingewiesen, dass für das hier beschriebene symmetrische Herstellungsverfahren alle vorstehend anhand der Figuren 1 bis 4 beschriebenen asymmetrischen Aufbauten verwendet werden können.

Wie aus Figur 5a ersichtlich, sind oberhalb der Ablöseschicht 590 zwei elektronische Komponenten 520a sowie 520b eingebettet. Dabei ist die jeweilige elektronische Komponente 520a, 520b von oben und von der Seite vollständig in die dielektrische Schicht 510 mit ihren vorteilhaften mechanischen und thermischen Eigenschaften eingebettet. An der Unterseite der beiden elektronischen Komponenten 520a sowie 520b liegt die Ablöseschicht 590 an.

In entsprechender Weise sind unterhalb der Ablöseschicht 590 zwei elektronische Komponenten 520c sowie 520d eingebettet. Diese sind an ihrer Unterseite sowie an ihren seitlichen Flächen vollständig von der dielektrischen Schicht 514 umgeben. An der Oberseite der beiden elektronischen Komponenten 520c sowie 520d liegt die Ablöseschicht 590 an.

Ferner sind, wie ebenfalls aus Figur 5a ersichtlich, eine Vielzahl von Vias 560 für jeweils eine geeignete elektrische Kontaktierung ausgebildet.

Die Figuren 5b und 5c zeigen die zwei asymmetrischen Leiterplatten 500a und 500b, welche durch ein Auftrennen des Schichtenverbundes 505 an der Ablöseschicht sowie an den flächig vergleichsweise kleinen Teilbereichen der dielektrischen Schicht 512 entstehen. Die Teile der Ablöseschicht, welche nach dem Auftrennen entstehen, sind in den Figuren 5B und 5C mit den Bezugszeichen 590a bzw. 590b gekennzeichnet.

Der Vorteil der hier beschriebenen Herstellung von zwei asymmetrischen Leiterplatten 500a und 500b besteht darin, dass etliche in Figur 5 nicht dargestellte Prozessierungsschritte an dem im wesentlichen symmetrischen Schichtenaufbau 505 durchgeführt werden können.

Abschließend wird darauf hingewiesen, dass, wie bereits vorstehend in dem Kapitel Zusammenfassung der Erfindung beschrieben, anstelle von elektronischen Komponenten auch mechanische oder thermisch leitende Komponenten in der Leiterplatte eingebaut werden können.

### BEZUGSZEICHEN:

- 100: Leiterplatte mit eingebetteten elektronischen Komponenten
- 110: dielektrische Schicht
- 110a,b,c: dielektrische Teilschicht
- 120: elektronische Komponente
- 121: Spalt / Beabstandung
- 130: metallische Schicht / Metallfolie
- 132: metallische Schicht / Metallfolie
- 160: Vias

- 200: Leiterplatte mit eingebetteten elektronischen Komponenten
- 210: dielektrische Schicht
- 210b: dielektrische Teilschicht
- 250: dielektrische Kern-Schicht
- 234: metallische Schicht / Metallfolie

- 300: Leiterplatte mit eingebetteten elektronischen Komponenten
- 310: dielektrische Schicht
- 312: dielektrische Schicht
- 321: Spalt / Beabstandung
- 335: metallische Schicht
- 336: metallische Schicht
- 337: metallische Schicht
- 350: dielektrische Kern-Schicht
- 362: Vias
- 370: temporärer Träger / Tape

- 400a,b,c: Leiterplatte mit eingebetteter elektronischer Komponente
- 410a: dielektrische Teilschichten
- 410a': vereinigte dielektrische Schicht
- 410b: dielektrische Schicht
- 412a: dielektrische Teilschichten
- 412a': vereinigte dielektrische Schicht
- 412b: dielektrische Schicht
- 421: Hohlraum
- 435: metallische Schicht
- 436: metallische Schicht
- 437: metallische Schicht
- 438: metallische Schicht
- 450: dielektrische Kern-Schicht
- 480: Strich-Punkt-Linie

- 500a: Leiterplatte (asymmetrisch)
- 500b: Leiterplatte (asymmetrisch)
- 505: Leiterplattenstruktur (symmetrischer Schichtaufbau)
- 510: dielektrische Schicht
- 512: dielektrische Schicht
- 514: dielektrische Schicht
- 530: metallische Schicht
- 532: metallische Schicht
- 534: metallische Schicht
- 536: metallische Schicht
- 538: metallische Schicht
- 539: metallische Schicht
- 550: dielektrische Kern-Schicht
- 552: dielektrische Kern-Schicht
- 560: Vias
- 590: Ablöseschicht
- 590a/b: Teil von Ablöseschicht

## Patentansprüche

1. Leiterplatte aufweisend
eine dielektrische Schicht (312), welche parallel zu einer xy-Ebene, die durch eine x-Achse und eine dazu senkrechte y-Achse aufgespannt ist, eine flächige Ausdehnung aufweist und entlang einer z-Richtung, welche senkrecht zu der x-Achse und zu der y-Achse ist, eine Schichtdicke aufweist;
eine metallische Schicht (336), welche flächig an der dielektrischen Schicht (312) angebracht ist; und
eine Komponente (120), welche in der dielektrischen Schicht (312) und/oder in einer dielektrischen Kern-Schicht (350) der Leiterplatte (300) eingebettet ist; wobei
die dielektrische Schicht (312) ein dielektrisches Material aufweist, welches ein Elastizitätsmodul E im Bereich zwischen 1 und 20 GPa und
entlang der x-Achse und entlang der y-Achse einen thermischen Ausdehnungskoeffizienten im Bereich zwischen 0 und 17 ppm/K hat,
**dadurch gekennzeichnet, dass** das dielektrisches Material ein Kriechverhalten aufweist, welches durch zumindest eine der folgenden Eigenschaften bestimmt ist:
(a) eine plastische Verformbarkeit im Bereich zwischen 0,01% und 10%, insbesondere im Bereich zwischen 0,1% und 5% und weiter insbesondere im Bereich zwischen 0,2% und 2%,
(b) eine viscoelastische Verformbarkeit im Bereich zwischen 0% und 10%, insbesondere im Bereich zwischen 0% und 5% und weiter insbesondere im Bereich zwischen 0% und 3%.

2. Leiterplatte gemäß Anspruch 1, wobei
das dielektrische Material eine Mischung oder ein Copolymer ist bestehend aus zumindest einem ersten Material mit einem ersten Elastizitätsmodul E und einem ersten thermischen Ausdehnungskoeffizienten und einem zweiten Material mit einem zweiten Elastizitätsmodul E und einem zweiten thermischen Ausdehnungskoeffizienten,
wobei das erste Elastizitätsmodul größer ist als das zweite Elastizitätsmodul und
wobei der erste thermische Ausdehnungskoeffizient kleiner ist als der zweite thermische Ausdehnungskoeffizient.

3. Leiterplatte gemäß Anspruch 2, wobei
das erste Material eine erste Glasübergangstemperatur aufweist und das zweite Material eine zweite Glasübergangstemperatur aufweist, wobei die erste Glasübergangstemperatur größer ist als die zweite Glasübergangstemperatur; und/oder wobei
das erste Material ein Harz und einen sich darin befindlichen harten Füllstoff aufweist; und/oder wobei
das zweite Material ein thermisch aushärtbares Harz aufweist, welches mit einem weichmachenden Stoff verbunden ist.

4. Leiterplatte gemäß einem der vorangehenden Ansprüche, wobei
der Wert für das Elastizitätsmodul E im Bereich zwischen 2 und 7 GPa und insbesondere im Bereich zwischen 3 und 5 GPa liegt; und/oder wobei der thermische Ausdehnungskoeffizient im Bereich zwischen 3 und 10 ppm/K und insbesondere im Bereich zwischen 5 und 8 ppm/K liegt.

5. Leiterplatte gemäß einem der Ansprüche 1 bis 4, ferner aufweisend
die dielektrische Kern-Schicht (350), welche flächig an der metallischen Schicht (336) und/oder an der dielektrischen Schicht (312) angebracht ist;
wobei die Komponente (120) in der dielektrischen Kern-Schicht (350) eingebettet ist und die dielektrische Schicht (312) oberhalb oder unterhalb der dielektrischen Kern-Schicht (350) sowie der eingebetteten Komponente (120) angeordnet ist.

6. Leiterplatte gemäß Anspruch 5, wobei
die Komponente (120) in der dielektrischen Kern-Schicht (350) eingeklebt ist; und/oder wobei
die dielektrische Kern-Schicht (350) ein dielektrisches Kern-Material aufweist, welches entlang der x-Achse und entlang der y-Achse einen thermischen Ausdehnungskoeffizienten von 0 bis 11 ppm/K, insbesondere von 2 bis 10 ppm/K und weiter bevorzugt von 3 bis 9 ppm/K hat.

7. Leiterplatte gemäß einem der vorangehenden Ansprüche 1 bis 4, wobei
die Komponente (120) in der dielektrischen Schicht (312) eingebettet ist; und/oder wobei
die dielektrische Schicht eine dielektrische Prepreg-Schicht ist und/oder das dielektrische Material ein dielektrisches Prepreg-Material ist; und/oder wobei
die Gesamtdicke des Schichtenverbundes kleiner ist als ungefähr 200 µm, insbesondere kleiner als ungefähr 190 µm und weiter insbesondere kleiner als ungefähr 180 µm.

8. Leiterplatte gemäß einem der Ansprüche 1 bis 7, welche in Bezug zu einer Ebene der eingebetteten Komponente (120) entlang einer Achse einen asymmetrischen Aufbau aufweist, wobei
- die Ebene parallel zu der flächigen Oberfläche der dielektrischen Schicht (312) orientiert ist,
- die Ebene die eingebettete Komponente (120) in der Mitte schneidet, und
- die Achse senkrecht zu dieser Ebenen steht.

9. Verfahren zum Herstellen einer Leiterplatte (300), insbesondere einer Leiterplatte (300) gemäß einem der vorangehenden Ansprüche, das Verfahren aufweisend
Bereitstellen einer dielektrischen Schicht (312), welche parallel zu einer xy-Ebene, die durch eine x-Achse und eine dazu senkrechte y-Achse aufgespannt ist, eine flächige Ausdehnung aufweist und entlang einer z-Richtung, welche senkrecht zu der x-Achse und zu der y-Achse ist, eine Schichtdicke aufweist; und
Einbetten einer Komponente (120) in der dielektrischen Schicht (312) und/oder in einer dielektrischen Kern-Schicht (350) der Leiterplatte (300), wobei die dielektrische Kern-Schicht (350) an der dielektrischen Schicht (312) angebracht ist; wobei
die dielektrische Schicht (312) ein dielektrisches Material aufweist, welches ein Elastizitätsmodul E im Bereich zwischen 1 und 20 GPa und
entlang der x-Achse und entlang der y-Achse einen thermischen Ausdehnungskoeffizienten im Bereich zwischen 0 und 17 ppm/K hat,
**dadurch gekennzeichnet, dass**
das dielektrisches Material ein Kriechverhalten aufweist, welches durch zumindest eine der folgenden Eigenschaften bestimmt ist:
(a) eine plastische Verformbarkeit im Bereich zwischen 0,01% und 10%, insbesondere im Bereich zwischen 0,1% und 5% und weiter insbesondere im Bereich zwischen 0,2% und 2%,
(b) eine viscoelastische Verformbarkeit im Bereich zwischen 0% und 10%, insbesondere im Bereich zwischen 0% und 5% und weiter insbesondere im Bereich zwischen 0% und 3%.

10. Verfahren gemäß Anspruch 9, ferner aufweisend
Ausbilden einer Ausnehmung in der dielektrischen Schicht (312) und/oder in der dielektrischen Kern-Schicht (350); wobei das Einbetten der Komponente (120) aufweist:
Einbringen der Komponente (120) in die Ausnehmung.

11. Verfahren gemäß Anspruch 10, wobei
das Einbetten der Komponente (120) ferner aufweist:
Einbringen eines adhäsiven Materials in die Ausnehmung; und/oder wobei
die Ausnehmung größer ist als die Komponente (120), so dass nach einem Einbringen der der Komponente (120) in die Ausnehmung ein Hohlraum (421) verbleibt.

12. Verfahren gemäß einem der Ansprüche 9 bis 11, ferner aufweisend falls die Komponente (120) in der dielektrischen Schicht (312) eingebettet ist,
Aufbringen einer weiteren dielektrischen Schicht (310) auf die dielektrische Schicht (312) und die Komponente (120), wobei die weitere dielektrische Schicht (310) die gleichen Eigenschaften hat wie die dielektrische Schicht (310); und
falls die Komponente (120) in der dielektrischen Kern-Schicht (350) eingebettet ist,
Aufbringen der dielektrischen Schicht (312) auf die dielektrische Kern-Schicht (350) und die Komponente (350).

13. Verfahren gemäß einem der Ansprüche 9 bis 12, ferner aufweisend
Ausbilden einer metallischen Schicht (336) an der dielektrischen Schicht; und/oder
Verpressen sämtlicher Schichten der Leiterplatte (300).

14. Verfahren zum Herstellen von zwei prozessierten Leiterplatten, das Verfahren aufweisend
Aufbauen eines Schichtenverbundes (505) aufweisend
eine erste Leiterplatte (500a) gemäß Anspruch 8,
eine zweite Leiterplatte (500b) gemäß Anspruch 8, und
eine Ablöseschicht (590), welche zwischen der ersten Leiterplatte und der zweiten Leiterplatte angeordnet ist;
Prozessieren des gesamten Schichtenverbundes (505); und
Auftrennen der Schichtenverbundes (505) an der Ablöseschicht (590), so dass eine erste prozessierte Leiterplatte (500a) und eine zweite prozessierte Leiterplatte (500b) mit jeweils einem asymmetrischen Schichtaufbau entstehen,
**dadurch gekennzeichnet, dass**
das dielektrisches Material ein Kriechverhalten aufweist, welches durch zumindest eine der folgenden Eigenschaften bestimmt ist:
(a) eine plastische Verformbarkeit im Bereich zwischen 0,01% und 10%, insbesondere im Bereich zwischen 0,1% und 5% und weiter insbesondere im Bereich zwischen 0,2% und 2%,
(b) eine viscoelastische Verformbarkeit im Bereich zwischen 0% und 10%, insbesondere im Bereich zwischen 0% und 5% und weiter insbesondere im Bereich zwischen 0% und 3%.

15. Verfahren gemäß Anspruch 14, wobei
der aufgebaute Schichtenverbund (505) entlang der z-Achse eine Symmetrieebene aufweist, welche parallel zu der xy-Ebene orientiert ist; und/oder wobei
die Ablöseschicht (590) ein druckfähiges Haftreduzierungsmaterial aufweist und wobei das Verfahren ferner aufweist
Drucken des Haftreduzierungsmaterials auf zumindest einen Teilbereich der ersten Leiterplatte (500a) oder auf zumindest einen Teilbereich der zweiten Leiterplatte (500a).

## Claims

1. Circuit board comprising
a dielectric layer (312) comprising parallel to an xy plane, which is spanned by an x-axis and a y-axis perpendicular thereto, a planar extent and having a layer thickness along a z-direction which is perpendicular to the x-axis and to the y-axis;
a metallic layer (336) surface-mounted to the dielectric layer (312); and
a component (120) which is embedded in the dielectric layer (312) and/or in a dielectric core layer (350) of the circuit board (300); wherein
the dielectric layer (312) comprises a dielectric material comprising a modulus of elasticity E in the range between 1 and 20 GPa and having a coefficient of thermal expansion in the range between 0 and 17 ppm/K along the x-axis and along the y-axis,
**characterized in that** the dielectric material has a creep behaviour determined by at least one of the following properties:
(a) a plastic deformability in the range between 0.01% and 10%, in particular in the range between 0.1% and 5% and further in particular in the range between 0.2% and 2%,
(b) a viscoelastic deformability in the range between 0% and 10%, in particular in the range between 0% and 5% and further in particular in the range between 0% and 3%.

2. Circuit board according to claim 1, wherein
the dielectric material is a blend or copolymer consisting of at least a first material having a first modulus of elasticity E and a first coefficient of thermal expansion and a second material having a second modulus of elasticity E and a second coefficient of thermal expansion,
the first modulus of elasticity being greater than the second modulus of elasticity, and
wherein the first coefficient of thermal expansion is less than the second coefficient of thermal expansion.

3. Circuit board according to claim 2, wherein
the first material has a first glass transition temperature and the second material has a second glass transition temperature, the first glass transition temperature being greater than the second glass transition temperature; and/or wherein
the first material comprises a resin and a hard filler therein; and/or wherein
the second material comprises a thermally curable resin bonded to a softening agent.

4. Circuit board according to one of the foregoing claims, wherein
the value for the modulus of elasticity E is in the range between 2 and 7 GPa and in particular in the range between 3 and 5 GPa; and/or wherein
the coefficient of thermal expansion is in the range between 3 and 10 ppm/K and in particular in the range between 5 and 8 ppm/K.

5. Circuit board according to any of Claims 1 to 4, further comprising
the dielectric core layer (350), which is surface-mounted to the metallic layer (336) and/or to the dielectric layer (312);
wherein the component (120) is embedded in the dielectric core layer (350) and the dielectric layer (312) is disposed above or below the dielectric core layer (350) and the embedded component (120).

6. Circuit board according to claim 5, wherein
the component (120) is adhered in the dielectric core layer (350); and/or wherein
the dielectric core layer (350) comprises a dielectric core material having along the x-axis and along the y-axis a coefficient of thermal expansion of from 0 to 11 ppm/K, in particular from 2 to 10 ppm/K and more preferably from 3 to 9 ppm/K.

7. Circuit board according to any of the preceding claims 1 to 4, wherein
the component (120) is embedded in the dielectric layer (312); and/or wherein the dielectric layer is a dielectric prepreg layer and/or
the dielectric material is a dielectric prepreg material; and/or wherein
the total thickness of the layered composite is less than approximately 200 µm, in particular less than approximately 190 µm and further in particular less than approximately 180 µm.

8. Circuit board according to any of Claims 1 to 7 comprising an asymmetric structure with respect to a plane of the embedded component (120) along an axis, where
- the plane is oriented parallel to the planar surface of the dielectric layer (312),
- the plane intersects the embedded component (120) at the center, and
- the axis is perpendicular to these planes.

9. Method of manufacturing a circuit board (300), in particular a circuit board (300) according to one of the preceding claims, comprising the following steps
providing a dielectric layer (312) comprising parallel to an xy plane, which is spanned by an x-axis and a y-axis perpendicular thereto, a planar extent and having a layer thickness along a z-direction which is perpendicular to the x-axis and to the y-axis; and
embedding a component (120) in the dielectric layer (312) and/or in a dielectric core layer (350) of the circuit board (300), the dielectric core layer (350) being attached to the dielectric layer (312); wherein
the dielectric layer (312) comprises a dielectric material comprising a modulus of elasticity E in the range between 1 and 20 GPa and having a coefficient of thermal expansion in the range between 0 and 17 ppm/K along the x-axis and along the y-axis,
**characterised in that**
the dielectric material has a creep behaviour determined by at least one of the following properties:
(a) a plastic deformability in the range between 0.01% and 10%, in particular in the range between 0.1% and 5% and further in particular in the range between 0.2% and 2%,
(b) a viscoelastic deformability in the range between 0% and 10%, in particular in the range between 0% and 5% and further in particular in the range between 0% and 3%.

10. Method according to claim 9, further comprising
forming a recess in the dielectric layer (312) and/or in the dielectric core layer (350); wherein
the embedding of the component (120) comprises:
inserting the component (120) into the recess.

11. Method according to claim 10, wherein
the embedding of the component (120) further comprises:
introducing an adhesive material into the recess; and/or wherein
the recess is larger than the component (120) so that a cavity (421) remains after insertion of the component (120) into the recess.

12. Method according to any of claims 9 to 11, further comprising
if the component (120) is embedded in the dielectric layer (312),
applying a further dielectric layer (310) on the dielectric layer (312) and the component (120), the further dielectric layer (310) having the same properties as the dielectric layer (310); and
if the component (120) is embedded in the dielectric core layer (350),
applying of the dielectric layer (312) on the dielectric core layer (350) and the component (350).

13. Method according to any of claims 9 to 12, further comprising
forming a metallic layer (336) on the dielectric layer; and/or
laminating of all layers of the circuit board (300).

14. Method of manufacturing two processed circuit boards, the method comprising
building a layered composite (505) comprising
a first circuit board (500a) as claimed in claim 8,
a second circuit board (500b) as claimed in claim 8, and
a release layer (590) disposed between the first circuit board and the second circuit board;
processing the entire layered composite (505); and
separating the layered composites (505) at the release layer (590) to form a first processed circuit board (500a) and a second processed circuit board (500b) each having an asymmetric layer structure,
**characterised in that**
the dielectric material has a creep behaviour determined by at least one of the following properties:
(a) a plastic deformability in the range between 0.01% and 10%, in particular in the range between 0.1% and 5% and further in particular in the range between 0.2% and 2%,
(b) a viscoelastic deformability in the range between 0% and 10%, in particular in the range between 0% and 5% and further in particular in the range between 0% and 3%.

15. Method according to claim 14, wherein
the built-up layered composite (505) has, along the z-axis, a symmetry plane which is oriented parallel to the xy plane; and/or wherein
the release layer (590) comprises a printable adhesion reducing material, and wherein the method further comprises
printing the adhesion reducing material on at least a portion of the first circuit board (500a) or on at least a portion of the second circuit board (500a).

## Revendications

1. Carte de circuits imprimés présentant
une couche diélectrique (312) qui
présente, parallèlement à un plan xy qui est défini par un axe x et un axe y perpendiculaire à celui-ci, une extension plane et présente, le long d'un sens z qui est perpendiculaire à l'axe x et à l'axe y, une épaisseur de couche ;
une couche métallique (336) qui est montée à plat sur la couche diélectrique (312) ; et
un composant (120) qui est intégré dans la couche diélectrique (312) et/ou dans une couche centrale diélectrique (350) de la carte de circuits imprimés (300) ;
la couche diélectrique (312) présentant un matériau diélectrique qui a un module d'élasticité E dans la plage entre 1 et 20 GPa et, le long de l'axe x et le long de l'axe y, un coefficient d'extension thermique dans la plage entre 0 et 17 ppm/K,
**caractérisée en ce que** le matériau diélectrique présente un comportement au fluage qui est déterminé par au moins une des propriétés suivantes :
(a) une déformabilité plastique dans la plage entre 0,01 % et 10 %, en particulier dans la plage entre 0,1 % et 5 % et plus particulièrement dans la plage entre 0,2 % et 2 %,
(b) une déformabilité viscoélastique dans la plage entre 0 % et 10 %, en particulier dans la plage entre 0 % et 5 % et plus particulièrement dans la plage entre 0 % et 3 %.

2. Carte de circuits imprimés selon la revendication 1, **caractérisée en ce que**
le matériau diélectrique est un mélange ou un copolymère se composant d'au moins un premier matériau avec un premier module d'élasticité E et un premier coefficient d'extension thermique et un second matériau avec un second module d'élasticité E et un second coefficient d'extension thermique,
le premier module d'élasticité est supérieur au second module d'élasticité et
le premier coefficient d'extension thermique est inférieur au second coefficient d'extension thermique.

3. Carte de circuits imprimés selon la revendication 2, **caractérisée en ce que**
le premier matériau présente une première température de transition vitreuse et le second matériau présente une seconde température de transition vitreuse, la première température de transition vitreuse étant supérieure à la seconde température de transition vitreuse ; et/ou
le premier matériau présente une résine et une substance de remplissage dure se trouvant dans celle-ci ; et/ou
le second matériau présente une résine thermodurcissable qui est reliée à une substance émolliente.

4. Carte de circuits imprimés selon l'une quelconque des revendications précédentes, **caractérisée en ce que**
la valeur pour le module d'élasticité E se trouve dans la plage entre 2 et 7 GPa et en particulier dans la plage entre 3 et 5 GPa ; et/ou
le coefficient d'extension thermique se trouve dans la plage entre 3 et 10 ppm/K et en particulier dans la plage entre 5 et 8 ppm/K.

5. Carte de circuits imprimés selon l'une quelconque des revendications 1 à 4, présentant en outre
la couche centrale diélectrique (350) qui est montée à plat sur la couche métallique (336) et/ou sur la couche diélectrique (312) ;
**caractérisée en ce que** le composant (120) est intégré dans la couche centrale diélectrique (350) et la couche diélectrique (312) est agencée au-dessus ou en dessous de la couche centrale diélectrique (350) ainsi que du composant (120) intégré.

6. Carte de circuits imprimés selon la revendication 5, **caractérisée en ce que**
le composant (120) est collé dans la couche centrale diélectrique (350) ; et/ou
la couche centrale diélectrique (350) présente un matériau central diélectrique qui a, le long de l'axe x et le long de l'axe y, un coefficient d'extension thermique de 0 à 11 ppm/K, en particulier de 2 à 10 ppm/K et de manière davantage préférée de 3 à 9 ppm/K.

7. Carte de circuits imprimés selon l'une quelconque des revendications précédentes 1 à 4, **caractérisée en ce que**
le composant (120) est intégré dans la couche diélectrique (312) ; et/ou
la couche diélectrique est une couche préimprégnée diélectrique et/ou le matériau diélectrique est un matériau préimprégné diélectrique ; et/ou
l'épaisseur entière du composite stratifié est inférieure à environ 200 µm, en particulier inférieure à environ 190 µm et plus particulièrement inférieure à environ 180 µm.

8. Carte de circuits imprimés selon l'une quelconque des revendications 1 à 7 qui présente, par rapport à un plan du composant (120) intégré le long d'un axe, une structure asymétrique, **caractérisée en ce que**
- le plan est orienté parallèlement à la surface plate de la couche diélectrique (312),
- le plan coupe au milieu le composant (120) intégré, et
- l'axe est perpendiculaire à ces plans.

9. Procédé de fabrication d'une carte de circuits imprimés (300), en particulier d'une carte de circuits imprimés (300) selon l'une quelconque des revendications précédentes, le procédé présentant
la fourniture d'une couche diélectrique (312) qui présente, parallèlement à un plan xy qui est défini par un axe x et un axe y perpendiculaire à celui-ci, une extension plate et, le long d'un sens z qui est perpendiculaire à l'axe x et à l'axe y, une épaisseur de couche ; et
l'intégration d'un composant (120) dans la couche diélectrique (312) et/ou dans une couche centrale diélectrique (350) de la carte de circuits imprimés (300), la couche centrale diélectrique (350) étant montée sur la couche diélectrique (312) ;
la couche diélectrique (312) présentant un matériau diélectrique qui a un module d'élasticité E dans la plage entre 1 et 20 GPa et, le long de l'axe x et le long de l'axe y, un coefficient d'extension thermique dans la plage entre 0 et 17 ppm/K,
**caractérisé en ce que**
le matériau diélectrique présente un comportement au fluage qui est déterminé par au moins une des propriétés suivantes :
(a) une déformabilité plastique dans la plage entre 0,01 % et 10 %, en particulier dans la plage entre 0,1 % et 5 % et plus particulièrement dans la plage entre 0,2 % et 2 %,
(b) une déformabilité viscoélastique dans la plage entre 0 % et 10 %, en particulier dans la plage entre 0 % et 5 % et plus particulièrement dans la plage entre 0 % et 3 %.

10. Procédé selon la revendication 9, présentant en outre
la réalisation d'un évidement dans la couche diélectrique (312) et/ou dans la couche centrale diélectrique (350) ; **caractérisé en ce que**
l'intégration du composant (120) présente :
l'introduction du composant (120) dans l'évidement.

11. Procédé selon la revendication 10, **caractérisé en ce que**
l'intégration du composant (120) présente en outre :
l'introduction d'un matériau adhésif dans l'évidement ; et/ou
l'évidement est plus grand que le composant (120) de sorte que, après une introduction du composant (120) dans l'évidement, il reste un espace creux (421).

12. Procédé selon l'une quelconque des revendications 9 à 11, présentant en outre, si le composant (120) est intégré dans la couche diélectrique (312),
l'application d'une autre couche diélectrique (310) sur la couche diélectrique (312) et le composant (120), **caractérisé en ce que** l'autre couche diélectrique (310) a les mêmes propriétés que la couche diélectrique (310) ; et
si le composant (120) est intégré dans la couche centrale diélectrique (350),
l'application de la couche diélectrique (312) sur la couche centrale diélectrique (350) et le composant (350).

13. Procédé selon l'une quelconque des revendications 9 à 12, présentant en outre
la réalisation d'une couche métallique (336) sur la couche diélectrique ; et/ou
le pressage de toutes les couches de la carte de circuits imprimés (300).

14. Procédé de fabrication de deux cartes de circuits imprimés traitées, le procédé présentant
l'établissement d'un composite stratifié (505) présentant
une première carte de circuits imprimés (500a) selon la revendication 8,
une seconde carte de circuits imprimés (500b) selon la revendication 8, et
une couche de détachement (590) qui est agencée entre la première carte de circuits imprimés et la seconde carte de circuits imprimés ;
le traitement du composite stratifié (505) entier ; et
la séparation du composite stratifié (505) sur la couche de détachement (590) de sorte qu'une première carte de circuits imprimés (500a) traitée et une seconde carte de circuits imprimés (500b) traitée apparaissent avec respectivement une structure de couche asymétrique,
**caractérisé en ce que**
le matériau diélectrique présente un comportement au fluage qui est déterminé par au moins une des propriétés suivantes :
(a) une déformabilité plastique dans la plage entre 0,01 % et 10 %, en particulier dans la plage entre 0,1 % et 5 % et plus particulièrement dans la plage entre 0,2 % et 2 %,
(b) une déformabilité viscoélastique dans la plage ente 0 % et 10 %, en particulier dans la plage entre 0 % et 5 % et plus particulièrement dans la plage entre 0 % et 3 %.

15. Procédé selon la revendication 14, **caractérisé en ce que**
le composite stratifié (505) structuré présente, le long de l'axe z, un plan de symétrie qui est orienté parallèlement au plan xy ; et/ou
la couche de détachement (590) présente un matériau de réduction d'adhérence imprimable et le procédé présentant en outre
l'impression du matériau de réduction d'adhérence sur au moins une zone partielle de la première carte de circuits imprimés (500a) ou sur au moins une zone partielle de la seconde carte de circuits imprimés (500a).
